(19) Europäisches Patentamt
European Patent Office
Office européen des brevets

(11) **EP 1 750 254 B1**

(12) **EUROPEAN PATENT SPECIFICATION**

(45) Date of publication and mention
of the grant of the patent:
**09.03.2011   Bulletin 2011/10**

(51) Int Cl.:
**G10L 19/14** *(2006.01)*      **G10L 19/00** *(2006.01)*
**G10L 19/02** *(2006.01)*      **G10L 19/06** *(2006.01)*
**G10L 19/08** *(2006.01)*      **G10L 19/12** *(2006.01)*

(21) Application number: **05739228.4**

(22) Date of filing: **13.05.2005**

(86) International application number:
**PCT/JP2005/008774**

(87) International publication number:
**WO 2005/114655 (01.12.2005 Gazette 2005/48)**

(54) **AUDIO/MUSIC DECODING DEVICE AND AUDIO/MUSIC DECODING METHOD**

AUDIO/MUSIKDECODIERUNGSEINRICHTUNG UND AUDIO/
MUSIKDECODIERUNGSVERFAHREN

DISPOSITIF DE DÉCODAGE AUDIO/MUSICAL ET PROCÉDÉ DE DÉCODAGE AUDIO/MUSICAL

(84) Designated Contracting States:
**DE FR GB IT**

(30) Priority: **24.05.2004   JP 2004153997**

(43) Date of publication of application:
**07.02.2007   Bulletin 2007/06**

(73) Proprietor: **Panasonic Corporation
Kadoma-shi
Osaka 571-8501 (JP)**

(72) Inventors:
• **SATO, Kaoru,
Mats. El. Ind. Co., IPROC, IP Dev. Ct
Osaka 540-6319 (JP)**
• **MORII, Toshiyuki,
Mats. El. Ind. Co., IPROC, IP
Chuo-ku, Osaka 540-6319 (JP)**
• **YAMANASHI, Tomofumi,
Mats. El. Ind. Co., IPROC, IP
Chuo-ku, Osaka 540-6319 (JP)**

(74) Representative: **Grünecker, Kinkeldey,
Stockmair & Schwanhäusser
Anwaltssozietät
Leopoldstrasse 4
80802 München (DE)**

(56) References cited:
EP-A- 1 688 916      EP-A- 1 785 984
EP-A- 1 793 373      JP-A- 2002 268 696
JP-A- 2002 268 696

• **RAMPRASHAD S A: "High quality embedded wideband speech coding using an inherently layered coding paradigm" ACOUSTICS, SPEECH, AND SIGNAL PROCESSING, 2000. ICASSP '00. PROCEEDINGS. 2000 IEEE INTERNATIONAL CONFERENCE ON 5-9 JUNE 2000, PISCATAWAY, NJ, USA,IEEE, vol. 2, 5 June 2000 (2000-06-05), pages 1145-1148, XP010504930 ISBN: 0-7803-6293-4**
• **ERDMANN C ET AL: "Pyramid CELP: embedded speech coding for packet communications" 2002 IEEE INTERNATIONAL CONFERENCE ON ACOUSTICS, SPEECH, AND SIGNAL PROCESSING. PROCEEDINGS. (ICASSP). ORLANDO, FL, MAY 13 - 17, 2002, IEEE INTERNATIONAL CONFERENCE ON ACOUSTICS, SPEECH, AND SIGNAL PROCESSING (ICASSP), NEW YORK, NY : IEEE, US, vol. VOL. 4 OF 4, 13 May 2002 (2002-05-13), pages I-181, XP010804677 ISBN: 0-7803-7402-9**
• **NOMURA ET AL: 'MPEG-4/CELP Onsei Fugoka Hoshiki.' THE INSTITUTE OF ELECTRONICS, INFORMATION AND COMMUNICATION ENGINEERS. vol. 98, no. 424, 20 November 1998, pages 19 - 26, XP002998381**

EP 1 750 254 B1

**Description**

Technical Field

The present invention relates to a speech/sound decoding apparatus and a speech/sound decoding method for use in a communication system in which speech/sound signals are encoded and transmitted.

Background Art

In the field of digital wireless communication, packet communication typified by Internet communication, or speech storage, speech signal encoding and decoding techniques are essential for effective use of the capacity of transmission paths of radio wave and storage media, and many speech encoding/decoding schemes have so far been developed. Among these, a CELP speech encoding and decoding scheme is put in practical use as a mainstream scheme (for example, see non-patent document 1).

The speech encoding apparatus of the CELP scheme encodes input speech based on pre-stored speech models. Specifically, a digital speech signal is separated into frames of approximately 10-20 ms, linear prediction analysis of speech signals is performed per frame, linear prediction coefficients and linear prediction residual vectors are obtained, and the linear prediction coefficients and linear prediction residual vectors are encoded individually. To carry out low bit rate communication, the amount of speech models that can be stored is limited, and therefore speech models are mainly stored in conventional CELP type speech encoding and decoding schemes

In communication systems where packets are transmitted, such as Internet communication, packet loss may occur depending on the network state, and it is thus desirable that, even if part of encoded information is lost, speech and sound can be decoded using the remaining part of encoded information. Similarly, invariable rate communication systems in which a bit rate varies depending on communication capacity, it is desirable that, when the communication capacity decreases, the burden on communication capacities is easy to reduce by transmitting a part of encoded information. As a technique capable of decoding speech/sound using all or part of encoded information in this way, a scalable coding technique has lately attracted attention. Several scalable coding schemes have been conventionally disclosed (for example, see patent document 1).

A scalable encoding scheme generally consists of a base layer and a plurality of enhancement layers, and these layers form a hierarchical structure in which the base layer is the lowest layer. At each layer, encoding of a residual signal that is a difference between input signal and output signal of the lower layer is performed. This configuration enables speech and sound decoding using encoded information at all layers or only encoded information at lower layers.

In the communication system transmitting the packet, when the decoding apparatus side cannot receive encoded information due to packet loss or the like, deterioration of decoded speech signals can be prevented to some degree by performing loss compensation (concealing). A method of concealing frame elimination is prescribed as a part of a decoding algorithm in, for example, ITU-T recommendation G.729.

Generally, loss compensation (concealing) processing recovers the current frame based on encoded information contained in a previously received frame. Decoded speech signals of the lost frame are produced by, for example, using encoded information contained in the frame immediately preceding the lost frame as encoded information for the lost frame; and gradually attenuating the energy of decoded signals which are generated using encoded information contained in the immediately preceding frame.

Patent Document 1: Japanese Patent Application Laid-Open No.Hei 10-97295
Non-patent Document 1: M.R.Schroeder, B. S. Atal, "Code Excited Linear Prediction: High Quality Speech at Low Bit Rate", IEEE proc., ICASSP'85 pp.937-940

JP2002 - 268969 relates to an encoding and decoding method for a sound signal which suppresses quality deterioration in case of frame loss. In CELP decoding if encoded codes of the next frame are lost, the sound signal of the next frame is decoded by using the encoded codes determined by the current frame and the periodicity information including the pitch information of the next frame.

Disclosure of Invention

Problems to be Solved by the Invention

However, conventional loss compensation (concealing) processing only recovers decoded speech signals using encoded information contained in the frame immediately preceding the lost frame and, although deterioration of encoded speech signals may be prevented to some degree, the quality of the decoded speech signals is not sufficient.

In the scalable encoding scheme, generally, the base layer encoded information is of high importance and, if the base layer encoded information is lost due to frame loss, it is impossible to obtain decoded speech signals with sufficient quality only by recovering the decoded speech signals using the encoded information contained in the immediately preceding frame.

It is therefore an object of the present invention to provide a speech/sound decoding apparatus as set fort in claims 1 and 12-14, and a speech/sound decoding method as set forth in claim 15, capable of obtaining decoded speech signals with sufficient quality, even if encoded information is lost due to a frame loss occurring in a scalable encoding scheme.

Means for Solving the Problem

A speech/sound decoding apparatus of the present invention is a speech/sound decoding apparatus that generates decoded signals by decoding encoded information encoded by scalable encoding and configured in a plurality of layers, adopts a configuration having: a frame loss detecting section that determines whether or not encoded information in each of the layers in a received frame is correct, and generates frame loss information that is a result of the determination; and decoding sections that are provided in the same number as the layers and that each determine encoded information to be used for decoding of each layer from the received encoded information and a plurality of previously received encoded information, according to the frame loss information, and generates decoded signals by performing decoding using the determined encoded information.

A speech/sound decoding method of the present invention is a speech/sound decoding method for generating decoded signals by decoding encoded information encoded by scalable encoding and configured in a plurality of layers, the speech/sound decoding method, having: a frame loss detection step of determining whether or not encoded information in each of the layers in a received frame is correct and generating frame loss information that is a result of the determination; and a decoding step, performed the same number of times as the number of the layers, of determining encoded information to be used for decoding in each layer from the received encoded information and a plurality of previously received encoded information, according to the frame loss information, and generating decoded signals by performing decoding using the determined encoded information.

Advantageous Effect of the Invention

According to the present invention, it is possible to improve decoded speech signal quality by obtaining decoded signals using encoded information obtained by another encoding section in addition to previously received encoded information, as compared with the case of using only the previously received encoded information.

Brief Description of Drawings

FIG.1 is a block diagram showing the configurations of an encoding apparatus and a decoding apparatus according to Embodiment 1 of the present invention;
FIG.2 is a block diagram showing an internal configuration of a first encoding section according to Embodiment 1 of the present invention;
FIG.3 illustrates processing for determining an adaptive excitation lag;
FIG.4 illustrates processing for determining a fixed excitation vector;
FIG.5 is a block diagram showing an internal configuration of a first local decoding section according to Embodiment 1 of the present invention;
FIG.6 is a block diagram showing an internal configuration of a second encoding section according to Embodiment 1 of the present invention;
FIG.7 is a diagram to outline processing for determining an adaptive excitation lag;
FIG.8 is a block diagram showing an internal configuration of a first decoding section according to Embodiment 1 of the present invention;
FIG.9 is a block diagram showing an internal configuration of a second decoding section according to Embodiment 1 of the present invention;
FIG.10 is a block diagram showing an internal configuration of an encoded information operation according to Embodiment 1 of the present invention;
FIG.11 is a block diagram showing an internal configuration of an encoded information operating section according to Embodiment 1 of the present invention;
FIG.12 shows a table listing frame loss information and parameters to be used by decoding sections according to Embodiment 1 of the present invention;

FIG.13 visually explains a principle of improving quality by adding second encoded information;

FIG.14A is a block diagram showing a configuration of a speech/sound transmission apparatus according to a second embodiment of the present invention; and

FIG.14B is a block diagram showing a configuration of a speech/sound reception apparatus according to Embodiment 2 of the present invention.

Best Mode for Carrying Out the Invention

A gist of the present invention is to improve the quality of decoded speech signals with a scalable encoding scheme utilizing a plurality of encoding sections, by outputting encoded information from each encoding section and transmitting the information to a decoding apparatus side, determining at the decoding apparatus side, whether encoded information is transmitted without loss, and, if a loss of encoded information is detected, performing decoding using encoded information outputted from another encoding section in addition to encoded information contained in a frame immediately preceding the lost frame.

Embodiments of the present invention will be described in detail below with reference to the accompanying drawings. Examples will be described where speech/sound encoding and decoding are performed according to the CELP scheme.

(Embodiment 1)

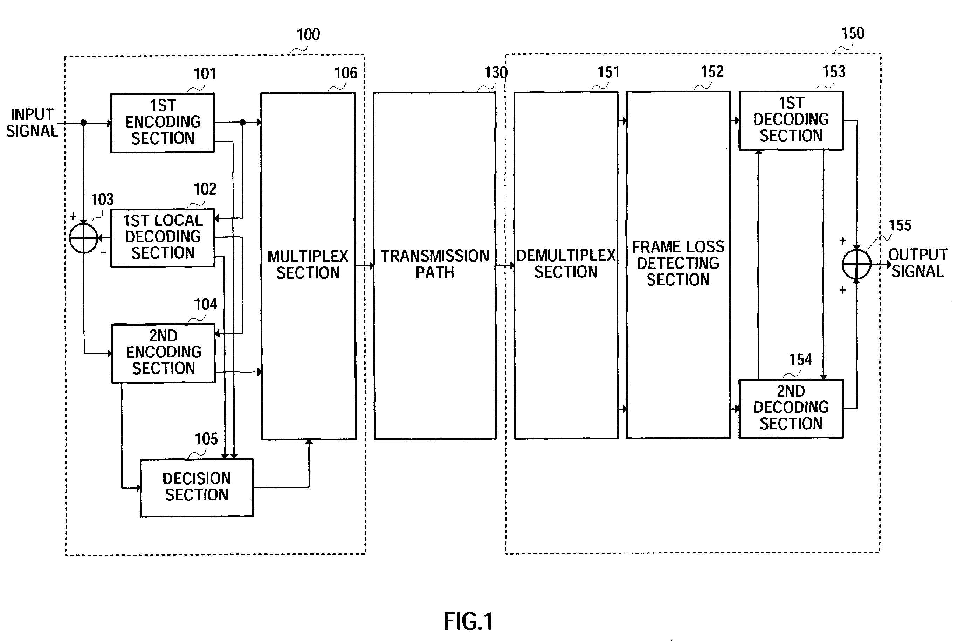

FIG.1 is a block diagram showing the main configurations of encoding apparatus 100 and decoding apparatus 150 according to Embodiment 1 of the present invention.

Encoding apparatus 100 is mainly configured with first encoding section 101, first local decoding section 102, adder 103, second encoding section 104, decision section 105 and multiplex section 106. Decoding apparatus 150 is mainly configured with demultiplex section 151, frame loss detecting section 152, first decoding section 153, second decoding section 154 and adder 155. Encoded information outputted from encoding apparatus 100 is transmitted to decoding apparatus 150 via transmission path 130.

The processing of each section of encoding apparatus 100 will be described blow. Speech/sound signals that are input signals are inputted to first encoding section 101 and adder 103.

First encoding section 101 obtains first encoded information from an inputted speech/sound signal using the speech/sound encoding method of the CELP scheme, and outputs the first encoded information to first local decoding section 102 and multiplex section 106.

First local decoding section 102 decodes the first encoded information outputted from first encoding section 101 into a first decoded signal using the speech/sound decoding method of the CELP scheme, and outputs the decoded signal obtained by this decoding to adder 103.

Adder 103 reverses the polarity of the first decoded signal outputted from first local decoding section 102 and adds this signal to an inputted speech/sound signal, and outputs a residual signal resulting from the addition to second encoding section 104.

Second encoding section 104 obtains second encoded information from the residual signal outputted from adder 103 using the speech/sound decoding method of the CELP scheme, and outputs the second encoded information to multiplex section 106.

Decision section 105 generates flag information by a method which will be described later and outputs this flag information to multiplex section 106. Here, the "flag information" refers to information indicating whether, if first encoded information loss is detected at decoding apparatus 150, first decoding section 153 should include second encoded information as encoded information to be used for decoding. As the flag information, a value of "0" or "1" is used here. When the flag information is "0", first decoding section 153 performs decoding using only first encoded information in the preceding frame. When the flag information is "1", first decoding section 153 performs decoding using the first encoded information in the preceding frame and the second encoded information.

Multiplex section 106 multiplexes first encoded information outputted from first encoding section 101, second encoded information outputted from second encoding section 104, and flag information outputted from decision section 105, and outputs multiplex information to transmission path 130.

It is assumed in the present description that encoding apparatus 100 performs speech/sound signal encoding on a per frame basis, stores first encoded information and second encoded information in one frame in respective packets, and transmits these packets. In one frame, thus, there are twopackets: a packet containing first encoded information and a packet containing second encoded information. For each frame, these two packets are transmitted to decoding apparatus 150. When a packet loss occurs, at least one of the first encoded information and the second encoded information is lost.

Then, processing of each section of decoding apparatus 150 will be described. Demultiplex section 151 demultiplexes multiplex information transmitted from encoding apparatus 100 into first encoded information, second encoded information and flag information, and outputs the first and second encoded information to frame loss detecting section 152 and the flag information to first decoding section 153.

Frame loss detecting section 152 determines whether the first and second encoded information outputted from demultiplex section 151 is received correctly and generates frame loss information indicating the determination result. As a method for detecting frame loss, for example, a method of monitoring identification information attached to packets is known. The receiving side monitors identification information attached to a packet such as, for example, the sequence number of the packet (packet number), the time stamp indicating the time the packet was generated, and detects the packet loss by detecting discontinuity of such identification information. As the identification information, for example, communication protocol TCP/IP sequence numbers, UDP/IP sequence numbers, time stamp information may be used.

As the frame loss information, values of "0" to "3" are used here. The frame loss information assumes a value of "0", if neither the first encoded information nor the second encoded information is received correctly; a value of "1", if the first encoded information is received correctly, but the second code is not received correctly; a value of "2", if the second encoded information is received correctly, but the first encoded information is not received correctly; and a value of "3", if both the first encoded information and the second encoded information are received correctly. Then, frame loss detecting section 152 outputs the frame loss information to first decoding section 153 and second decoding section 154. Next, frame loss detecting section 152 outputs correctly received encoded information to the corresponding decoding section. Specifically, frame loss detecting section 152 outputs the first encoded information to first decoding section 153, if the frame loss information is "1" or "3" (when the first encoded information is received correctly), and outputs the second encoded information to second decoding section 154, if the frame loss information is "2" or "3" (when the second encoded information is received correctly).

First decoding section 153 receives the flag information from demultiplex section 151 and receives the frame loss information from frame loss detecting section 152. Also, first decoding section 153 is provided with a buffer inside for storing first encoded information in the immediately preceding frame and may use the first encoded information in the immediately preceding frame stored in the buffer for decoding, if the first encoded information in the current frame is not received correctly.

Then, first decoding section 153 refers to the frame loss information. If the frame loss information is "1" or "3" (when the first encoded information is received correctly), first decoding section 153 receives the first encoded information from frame loss detecting section 152 and decodes the first encoded information using the speech/sound decoding method of the CELP scheme. If the frame loss information is "0", first decoding section 153 decodes the first encoded information in the immediately preceding frame using the speech/sound decoding method of the CELP scheme. If the frame loss information is "2", first decoding section 153 receives the second encoded information and decodes encoded information obtained from the second encoded information and the first encoded information in the immediately preceding frame using the speech/sound decoding method of the CELP scheme. However, first decoding section 153 does not use the second encoded information, if the flag information is "0".

In this embodiment, the first encoded information is decoded, if the first encoded information is received correctly, and the first encoded information included in the immediately preceding frame is decoded, if the first encoded information is not received correctly. In this embodiment, it is intended to further improve the decoded signal quality using the second encoded information in addition to the first encoded information included in the immediately preceding frame, if the first encoded information is not received correctly.

Then, first decoding section 153 outputs a first decoded signal obtained by decoding to adder 155. Also, first decoding section 153 outputs the first encoded information to second decoding section 154, if the frame loss information is "1" or "3". Also, first decoding section 153 outputs the first encoded information in the immediately preceding frame to second decoding section 154, if the frame loss information is "0" or "2".

A specific method of decoding encoded information by first decoding section 153 will be described later.

Second decoding section 154 receives the frame loss information from frame loss detecting section 152. Also, second decoding section 154 is provided with a buffer inside for storing second encoded information in the immediately preceding frame and may use the second encoded information in the immediately preceding frame stored in the buffer for decoding, if the second encoded information in the current frame is not received correctly.

Then, second decoding section 154 refers to the frame loss information. If the frame loss information is "3", second decoding section 154 receives the second encoded information from frame loss detecting section 152 and decodes the second encoded information using the speech/sound decoding method of the CELP scheme. If the frame loss information is "2", second decoding section 154 receives the second encoded information from frame loss detecting section 152, receives the first encoded information in the immediately preceding frame from first decoding section 153, and decodes encoded information obtained from the second encoded information and the first encoded information in the immediately preceding frame using the speech/sound decoding method of the CELP scheme. If the frame loss information is "1", second decoding section 154 receives the first encoded information from first decoding section 153

and decodes encoded information obtained from the first encoded information and the second encoded information in the immediately preceding frame using the speech/sound decoding method of the CELP scheme. If the frame loss information is "0", second decoding section 154 receives the first encoded information in the immediately preceding frame from first decoding section 153 and decodes encoded information obtained from the first encoded information in the immediately preceding frame and the second encoded information in the immediately preceding frame using the speech/sound decoding method of the CELP scheme.

As described above, second decoding section 154 performs decoding using the second encoded information and the first encoded information or the first encoded information in the immediately preceding frame, if the second encoded information is received correctly, and performs decoding using the second encoded information in the immediately preceding frame and the first encoded information or the first encoded information in the immediately preceding frame, if the second encoded information is not received correctly.

Then, second decoding section 154 outputs a second decoded signal obtained by decoding to adder 155. Also, second decoding section 154 outputs the second encoded information to first decoding section 153, if the frame loss information is "2".

A specific method of decoding encoded information by second decoding section 154 will be described later.

Adder 155 receives the first decoded signal from first decoding section 153 and the second decoded signal from second decoding section 154, adds the first decoded signal and the second decoded signal, and output a decoded signal resulting from the addition as an output signal.

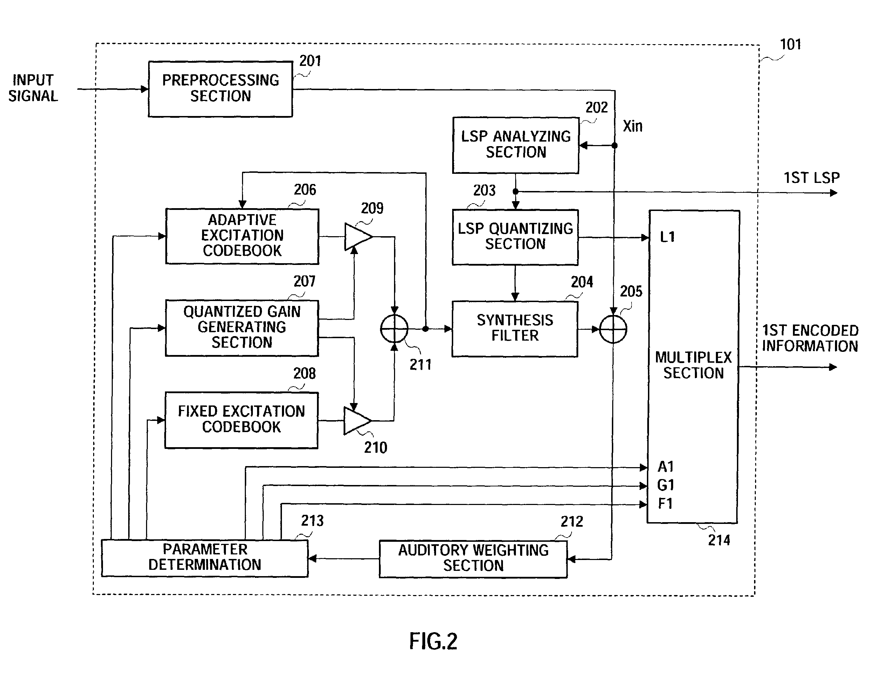

Next, an internal configuration of first encoding section 101 of encoding apparatus 100 will be described. FIG. 2 is a block diagram showing the internal configuration of first encoding section 101. First encoding section 101 separates an inputted speech/sound signal per N samples (N is a natural number) and performs encoding per frame.

Input signals for first encoding section 101 are inputted to preprocessing section 201. Preprocessing section 201 performs high-pass filtering processing for removing a DC component, waveform shaping processing which helps to improve the performance of subsequent encoding processing, and pre-emphasizing processing, and outputs the processed signals (Xin) to LSP analyzing section 202 and adder 205.

LSP analyzing section 202 performs linear prediction analysis using the Xin, converts LPC (Linear Prediction Coefficients) resulting from the analysis into LSP (Line Spectral Pairs), and outputs the conversion result as a first LSP to LSP quantizing section 203 and decision section 105.

LSP quantizing section 203 quantizes the first LSP outputted from LSP analyzing section 202 and outputs the quantized first LSP (first quantized LSP) to synthesis filter 204. Also, LSP quantizing section 203 outputs a first quantized LSP code (L1) indicating the first quantized LSP to multiplex section 214.

Synthesis filter 204 performs filter synthesis of a driving excitation, outputted from adder 211 which will be described later, by a filter coefficient based on the first quantized LSP, and thereby generates a synthesis signal, and outputs the synthesis signal to adder 205.

Adder 205 reverses the polarity of the synthesis signal, adds this signal to Xin, thereby calculating an error signal, and outputs the error signal to auditory weighting section 212.

Adaptive excitation codebook 206 has a buffer storing driving excitations which have so far been outputted by adder 211, extracts a set of samples for one frame from the buffer at an extraction position specified by a signal outputted from parameter determination section 213, and outputs the sample set as a first adaptive excitation vector to multiplier 209. Also, adaptive excitation codebook 206 updates the buffer, each time a driving excitation is inputted from adder 211.

Quantized gain generating section 207 determines a first quantized adaptive excitation gain and a first quantized fixed excitation gain, according to a signal outputted from parameter determination section 213, and outputs these gains to multiplier 209 and multiplier 210, respectively.

Fixed excitation codebook 208 outputs a vector having a form that is determined by a signal outputted from parameter determination section 213 as a first fixed excitation vector to multiplier 210.

Multiplier 209 multiples the first quantized adaptive excitation gain outputted from quantized gain generating section 207 by the first adaptive excitation vector outputted from adaptive excitation codebook 206 and outputs the result to adder 211. Multiplier 210 multiples the first quantized fixed excitation gain outputted from quantized gain generating section 207 by the first fixed excitation vector outputted from fixed excitation codebook 208 and outputs the result to adder 211.

Adder 211 receives the first adaptive excitation vector and the first fixed excitation vector which were both multiplied by the respective gains from multiplier 209 and multiplier 210, respectively, adds the first adaptive excitation vector and the first fixed excitation vector multiplied by the respective gains, and outputs a driving excitation resulting from the addition to synthesis filter 204 and adaptive excitation codebook 206. The driving excitation inputted to adaptive excitation codebook 206 is stored into the buffer.

Auditory weighting section 212 applies an auditory weight to the error signal outputted from adder 205 and outputs a result as a coding distortion to parameter determination section 213.

Parameter determination section 213 selects a first adaptive excitation lag that minimizes the coding distortion outputted from auditory weighting section 212 from adaptive excitation codebook 206 and outputs a first adaptive excitation lag code (A1) indicating a selected lag to multiplex section 214. Here, the "first adaptive excitation lag" is an extraction position where the first adaptive excitation vector is extracted, and its detailed description will be provided later. Also, parameter determination section 213 selects a first fixed excitation vector that minimizes the coding distortion outputted from auditory weighting section 212 from fixed excitation codebook 208 and outputs a first fixed excitation vector code (F1) indicating a selected vector to multiplex section 214. Furthermore, parameter determination section 213 selects a first quantized adaptive excitation gain and a first quantized fixed excitation gain that minimize the coding distortion outputted from auditory weighting section 212 from quantized gain generating section 207 and outputs a first quantized excitation gain code (G1) indicating selected gains to multiplex section 214.

Multiplex section 214 receives the first quantized LSP code (L1) from LSP quantizing section 203 and receives the first adaptive excitation lag code (A1), the first fixed excitation vector code (F1) and the first quantized excitation gain code (G1) from parameter determination section 213, multiplexes these information, and outputs the result as the first encoded information.

Next, processing in which LSP quantizing section 203 determines the first quantized LSP will be outlined, taking an example where the number of bits assigned to the first quantized LSP code (L1) is "8".

LSP quantizing section 203 is provided with a first LSP codebook in which 256 variants of first LSP code vectors $lsp_1^{(11)}(i)$ which are created in advance are stored. Here, 11 is an index attached to the first LSP code vectors, taking a value from 0 to 255. The first LSP code vectors $lsp_1^{(11)}(i)$ are N-dimensional vectors with i taking a value from 0 to N - 1. LSP quantizing section 203 receives the first $LSP\alpha(i)$ outputted from LSP analyzing section 202. Here, the first $LSP\alpha(i)$ is N-dimensional vectors.

Then, LSP quantizing section 203 obtains squared error $er_1$ between the first $LSP\alpha(i)$ and the first LSP code vector $lsp_1^{(11)}(i)$ by equation (1).

$$er_1 = \sum_{i=0}^{N-1} \left( \alpha_1(i) - lsp_1^{(11)}(i) \right)^2 \qquad \cdot \cdot \cdot \ (\ 1\ )$$

After obtaining squared errors $er_1$ for all 11 indexes, LSP quantizing section 203 then determines a value of 11 that minimizes squared error $er_1$ ($11_{min}$). Then, LSP quantizing section 203 outputs $11_{min}$ as the first quantized LSP code (L1) to multiplex section 214 and outputs $lsp_1^{(11min)}(i)$ as the first quantized LSP to synthesis filter 204.

$lsp_1^{(11min)}(i)$ obtained by LSP quantizing section 203, is the "first quantized LSP".

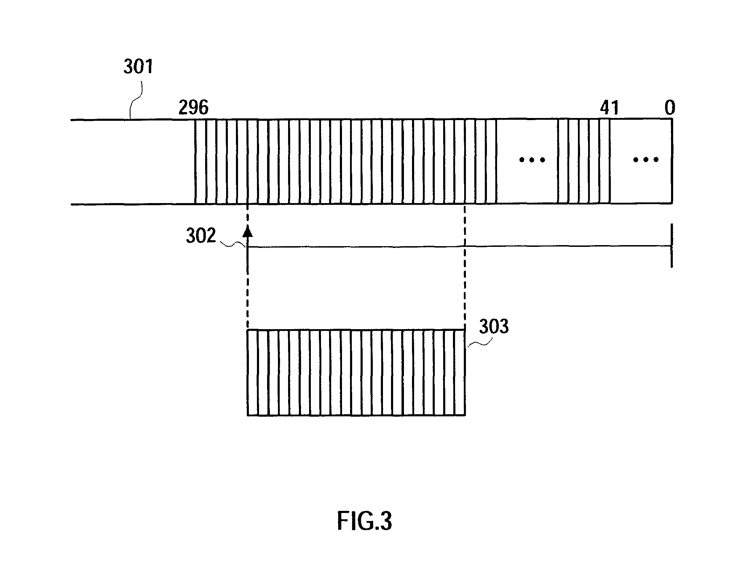

Next, processing in which parameter determination section 213 determines the first adaptive excitation lag will be described using FIG.3. In FIG.3, buffer 301 is the buffer provided by adaptive excitation codebook 206, position 302 is a first adaptive excitation vector extraction position, vector 303 is an extracted first adaptive excitation vector. Values "41" and "296" correspond to lower and upper limits of the range of shifting extraction position 302.

Assuming that the number of bits assigned to the code (A1) indicating the first adaptive excitation lag is "8", the range of shifting extraction position 302 can be set in a range of length of "256" (for example, 41 to 296). Additionally, the range of shifting extraction position 302 can be arbitrarily set.

Parameter determination section 213 shifts extraction position 302 within the set range and sequentially indicates extraction position 302 to adaptive excitation codebook 206. Then, adaptive excitation codebook 206 extracts first adaptive excitation vector 303 with a length of the frame by extraction position 302 indicated by parameter determination section 213 and outputs the extracted first adaptive excitation vector to multiplier 209. Then, parameter determination section 213 obtains the coding distortion which is outputted from auditory weighting section 212 for the case of extracting first adaptive excitation vectors 303 at all extraction positions 302, and determines extraction position 302 that minimizes the coding distortion.

Extraction position 302 from the buffer obtained by parameter determination section 213, is the "first adaptive excitation lag".

Then, parameter determination section 213 outputs the first adaptive excitation lag code (A1) indicating the first adaptive excitation lag that minimizes the coding distortion to multiplex section 214.

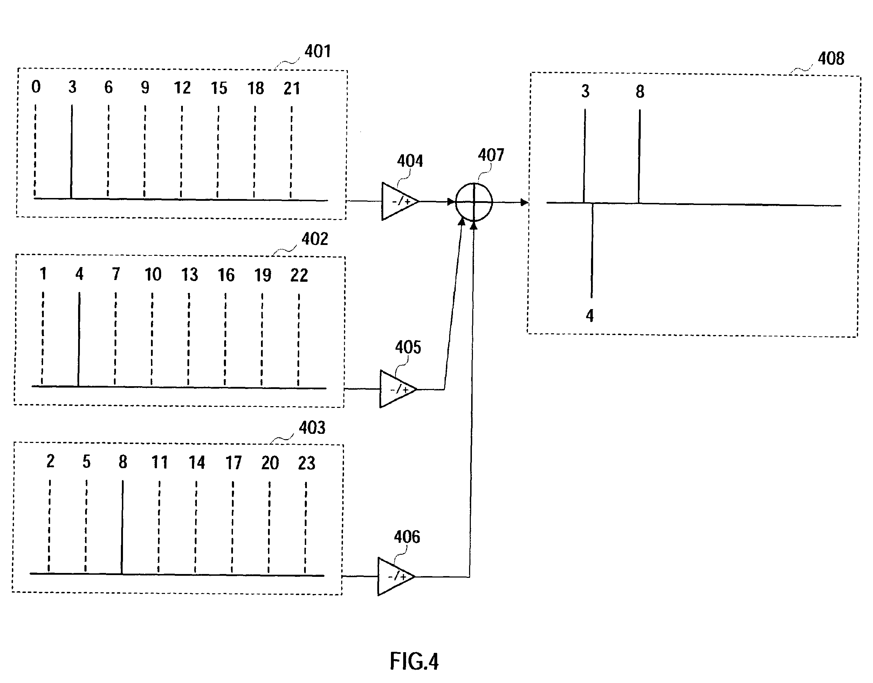

Next, processing in which parameter determination section 213 determines the first fixed excitation vector will be described using FIG. 4. Here, this will be explained, taking an example where "12" bits are assigned to the first fixed excitation vector code (F1).

In FIG.4, tracks 401, 402 and 403 each generate one unit pulse (with an amplitude value of 1). Multipliers 404, 405 and 406 assign polarity to the unit pluses generated by tracks 401, 402 and 403. Adder 407 adds the generated three unit pulses, and vector 408 is a "first fixed excitation vector" consisting of the three unit pulses.

Each track has different positions where a unit pulse can be generated. In FIG.4, the tracks are configured such that track 401 raises a unit pulse at one of eight positions { 0, 3, 6, 9, 12, 15, 18, 21 } , track 402 raises a unit pulse at one of eight positions { 1, 4, 7, 10, 13, 16, 19, 22 }, and track 403 raises a unit pulse at any of eight positions {2, 5, 8, 11, 14, 17, 20, 23}.

Then, polarity is assigned to the generated unit pulses by multipliers 404, 405 and 406, respectively, the three unit pulses are added by adder 407, and first fixed excitation vector 408 resulting from the addition is formed.

In the example of FIG.4, unit pulse has eight patterns of positions and two patterns of positions, positive and negative, and three bits for position information and one bit for polarity information are used to represent each unit pulse. Therefore, the fixed excitation codebook has 12 bits in total. Parameter determination section 213 shifts the positions of the three unit pulses and changes their polarity, and sequentially indicates the pulse positions and polarity to fixed excitation codebook 208. Then, fixed excitation codebook 208 configures first fixed excitation vectors 408 using the generation positions and polarity indicated by parameter determination section 213 and outputs the configured first fixed excitation vectors 408 to multiplier 210. Then, parameter determination section 213 obtains the coding distortion which is outputted from auditory weighting section 212 with regard to all combinations of the generation positions and polarity and determines a combination of the generation positions and polarity that minimizes the coding distortion. Then, parameter determination section 213 outputs the first fixed excitation vector code (F1) indicating the combination of the pulse positions and polarity that minimizes the coding distortion to multiplex section 214.

Next, processing in which parameter determination section 213 determines a first quantized adaptive excitation gain and a first quantized fixed excitation gain which are generated from quantized gain generating section 207, taking an example where "8" bits are assigned to the first quantized excitation gain code (G1). Quantized gain generating section 207 is provided with a first excitation gain codebook in which 256 variants of first excitation gain code vectors $gain_1^{(k1)}$ (i) which are created in advance are stored. Here, k1 is an index attached to the first excitation gain code vectors, taking a value from 0 to 255. The first excitation gain code vectors $gain_1^{(k1)}$ (i) are two-dimensional vectors with i taking a value from 0 to 1. Parameter determination section 213 sequentially indicates a value of k1 from 0 to 255 to quantized gain generating section 207. Quantized gain generating section 207 selects a first excitation gain code vector $gain_1^{(k1)}$ (i) from the first excitation gain codebooks using k1 indicated by parameter determination section 213 and outputs $gain_1^{(k1)}$ (0) as the first quantized adaptive excitation gain to multiplier 209 and $gain_1^{(k1)}$ (1) as the first quantized fixed excitation gain to multiplier 210.

$gain_1^{(k1)}$ (0) and $gain_1^{(k1)}$ (1), obtained by quantized gain generating section 207, are "first quantized adaptive excitation gain" and "first quantized fixed excitation gain". Parameter determination section 213 obtains the coding distortion which is outputted from auditory weighting section 212 with regard to all k1 indexes and determines a value of k1 ($k1_{min}$) that minimizes the coding distortion. Then, parameter determination section 213 outputs $K1_{min}$ as the first quantized excitation gain code (G1) to multiplex section 214.

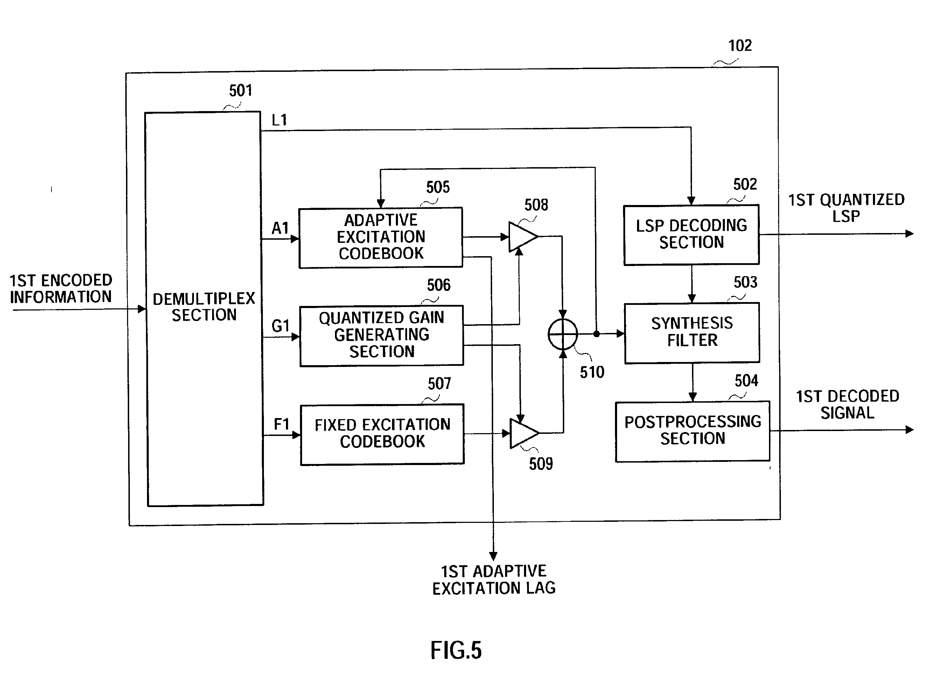

Next, an internal configuration of first local decoding section 102 will be described, using the block diagram shown in FIG.5. In FIG.5, first encoded information inputted to first local decoding section 102 is demultiplexed into individual codes (L1, A1, G1, and F1) by demultiplex section 501. The divided first quantized LSP code (L1) is outputted to LSP decoding section 502; the divided first adaptive excitation lag code (A1) is outputted to adaptive excitation codebook 505; the divided first quantized excitation gain code (G1) is outputted to quantized gain generating section 506; and the divided first fixed excitation vector code (F1) is outputted to fixed excitation codebook 507.

LSP decoding section 502 decodes the first quantized LSP code (L1) outputted from demultiplex section 501 into the first quantized LSP and outputs the decoded first quantized LSP to synthesis filter 503, second decoding section 104, and decision section 105.

Adaptive excitation codebook 505 extracts samples for one frame from its buffer at an extraction position specified by the first adaptive excitation lag code (A1) outputted from demultiplex section 501 and outputs the extracted vector as the first adaptive excitation vector to multiplier 508. Also, adaptive excitation codebook 505 outputs the extraction position specified by the first adaptive excitation lag code (A1) as the first adaptive excitation lag to second decoding section 104. Furthermore, adaptive excitation codebook 505 updates the buffer each time a driving excitation is inputted thereto from adder 510.

Quantized gain generating section 506 decodes the first quantized adaptive excitation gain and the first quantized fixed excitation gain which are specified by the first quantized excitation gain code (G1) outputted from demultiplex section 501 and outputs the first quantized adaptive excitation gain to multiplier 508 and the first quantized fixed excitation gain to multiplier 509.

Fixed excitation codebook 507 generates the first fixed excitation vector which is specified by the first fixed excitation vector code (F1) outputted from demultiplex section 501 and outputs the result to multiplier 509.

Multiplier 508 multiplies the first adaptive excitation vector by the first quantized adaptive excitation gain and outputs the result to adder 510. Multiplier 509 multiples the first fixed excitation vector by the first quantized fixed excitation gain and outputs the result to adder 510.

Adder 510 adds the first adaptive excitation vector and the first fixed excitation vector multiplied by the respective gains outputted from multipliers 508 and 509, generates a driving excitation, and outputs the driving excitation to synthesis filter 503 and adaptive excitation codebook 505. The driving excitation inputted to adaptive excitation codebook 505 is stored into the buffer.

Synthesis filter 503 performs filter synthesis on the driving excitation outputted from adder 510 with the filter coefficient decoded by LSP decoding section 502 and outputs a synthesis signal to postprocessing section 504.

Postprocessing section 504 processes the synthesis signal outputted from synthesis filter 503 by performing processing for improving a subjective speech quality, such as formant emphasizing and pitch emphasizing, and by performing processing for improving a subjective stationary noise quality, and outputs the processed signal as a first decoded signal.

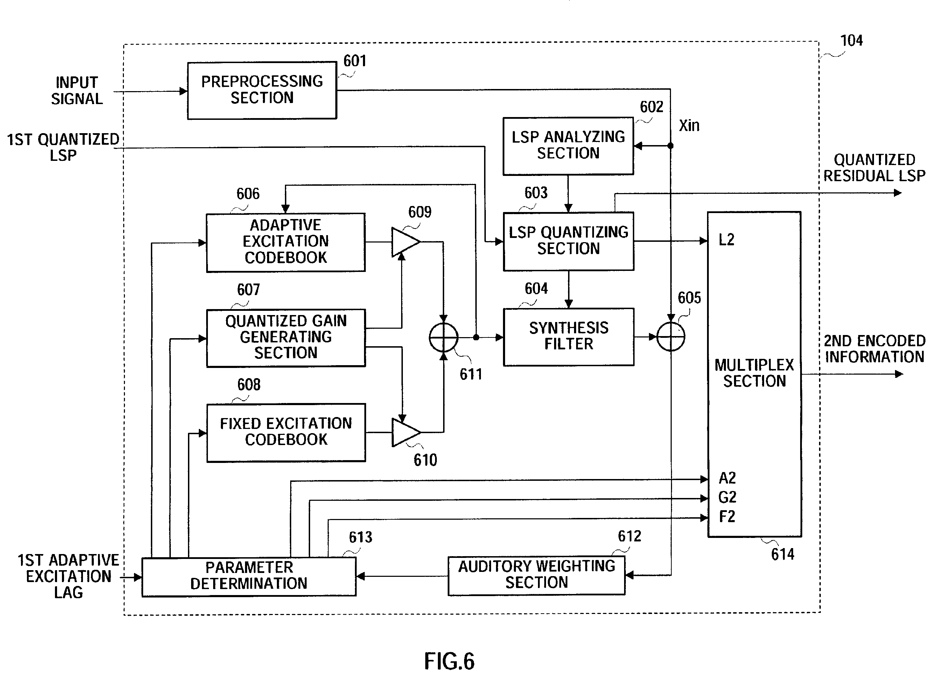

Next, an internal configuration of second encoding section 104 will be described using FIG.6. Second encoding section 104 separates inputted residual signals by N samples (N is a natural number) as one frame and encodes the frame for each frame, each frame containing N samples.

Input signals for second encoding section 104 are inputted to preprocessing section 601. Preprocessing section 601 performs high-pass filtering processing for removing a DC component and waveform shaping processing and pre-emphasizing processing which help to improve the performance of subsequent encoding, and outputs the processed signals (Xin) to LSP analyzing section 602 and adder 605.

LSP analyzing section 602 performs linear prediction analysis on the Xin, converts LPC (Linear Prediction Coefficients) resulting from the analysis into LSP (Line Spectral Pairs), and outputs the conversion result to LSP quantizing section 603 as second LSP.

LSP quantizing section 603 receives the first quantized LSP and the second LSP from LSP analyzing section 602. Then, LSP quantizing section 603 reverses the polarity of the first quantized LSP and adds this LSP to the second LSP, thus calculating a residual LSP. Then, LSP quantizing section 603 quantizes the residual LSP and adds the quantized residual LSP (quantized residual LSP) and the first quantized LSP, and thereby calculates second quantized LSP. Then, LSP quantizing section 603 outputs the second quantized LSP to synthesis filter 604 and outputs a second quantized LSP code (L2) indicating the quantized residual LSP to multiplex section 614 . Also, LSP quantizing section 603 outputs the quantized residual LSP to decision section 105.

Synthesis filter 604 performs filter synthesis of a driving excitation outputted from adder 611 which will be described later, by a filter coefficient based on the second quantized LSP, generates a synthesis signal, and outputs the synthesis signal to adder 605.

Adder 605 reverses the polarity of the synthesis signal, adds this signal to Xin, thereby calculating an error signal, and outputs the error signal to auditory weighting section 612.

Adaptive excitation codebook 606 has a buffer storing driving excitations which have so far been outputted by adder 611, extracts a set of samples for one frame from the buffer at an extraction position specified by the first adaptive excitation lag and a signal outputted from parameter determination section 613, and outputs the sample set as a second adaptive excitation vector to multiplier 609. Also, adaptive excitation codebook 606 updates the buffer, each time a driving excitation is inputted thereto from adder 611.

Quantized gain generating section 607 determines a second quantized adaptive excitation gain and a second quantized fixed excitation gain, according to a signal outputted from parameter determination section 613, and outputs these gains to multipliers 609 and 610, respectively.

Fixed excitation codebook 608 outputs a vector having a form that is specified by a signal outputted from parameter determination section 613 as a second fixed excitation vector to multiplier 610.

Multiplier 609 multiples the second quantized adaptive excitation gain outputted from quantized gain generating section 607 by the second adaptive excitation vector outputted from adaptive excitation codebook 606 and outputs the result to adder 611. Multiplier 610 multiples the second quantized fixed excitation gain outputted from quantized gain generating section 607 by the second fixed excitation vector outputted from fixed excitation codebook 608 and outputs the result to adder 611.

Adder 611 receives the second adaptive excitation vector and the second fixed excitation vector which were both multiplied by the respective gains from multiplier 609 and the multiplier 610, respectively, adds these vectors, and outputs a driving excitation resulting from the addition to synthesis filter 604 and adaptive excitation codebook 606. The driving excitation inputted to adaptive excitation codebook 606 is stored into the buffer.

Auditory weighting section 612 applies an auditory weight to the error signal outputted from adder 605 and outputs the result as a coding distortion to parameter determination section 613.

Parameter determination section 613 selects a second adaptive excitation lag that minimizes the coding distortion outputted from auditory weighting section 612 from adaptive excitation codebook 606 and outputs a second adaptive excitation lag code (A2) indicating a selected lag to multiplex section 614. Here, the "second adaptive excitation lag" is an extraction position where the second adaptive excitation vector is extracted, and its detailed description will be provided later. Also, parameter determination section 613 selects a second fixed excitation vector that minimizes the coding distortion outputted from auditory weighting section 612 from fixed excitation codebook 608 and outputs a second fixed excitation vector code (F2) indicating a selected vector to multiplex section 614. Furthermore, parameter determination section 613 selects a second quantized adaptive excitation gain and a second quantized fixed excitation gain that minimize the coding distortion outputted from auditory weighting section 612 from quantized gain generating section 607 and outputs a second quantized excitation gain code (G2) indicating selected gains to multiplex section 614.

Multiplex section 614 receives the second quantized LSP code (L2) from LSP quantizing section 603 and receives the second adaptive excitation lag code (A2), the second fixed excitation vector code (F2) and the second quantized excitation gain code (G2) from parameter determination section 613, multiplexes these information, and outputs the result as the second encoded information.

Next, processing in which LSP quantizing section 203 determines the first quantized LSP will be outlined, taking an example of vector-quantizing the residual LSP, assigning "8" bits to the second quantized LSP code (L2) .

LSP quantizing section 603 is provided with a second LSP codebook in which 256 variants of second LSP code vectors $lsp_{res}^{(12)}$ (i) which are created in advance are stored. Here, 12 is an index attached to the second LSP code vectors, ranging from 0 to 255. The second LSP code vectors $lsp_{res}^{(12)}$ (i) are N-dimensional vectors with i ranging from 0 to N - 1. LSP quantizing section 603 receives the second LSP$\alpha$(i) outputted from LSP analyzing section 602. Here, the second LSP$\alpha$(i) is N-dimensional vectors. Also, LSP quantizing section 603 receives the first quantized LSP $lsp_1^{(11min)}$ (i) outputted from first local decoding section 102. Here the first quantized LSP $lsp_1^{(11min)}$ (i) is N-dimensional vectors with i ranging from 0 to N-1.

Then, LSP quantizing section 603 obtains residual LSP res(i) by equation (2).

$$res(i) = \alpha_2(i) - lsp_1^{(l1_{\min})}(i) \quad (i = 0, \cdots, N-1) \qquad \cdots (2)$$

Then, LSP quantizing section 603 obtains squared error $er_2$ between the residual LSP res (i) and the second LSP code vectors $lsp_{res}^{(12)}$ (i) by equation (3).

$$er_2 = \sum_{i=0}^{N-1} \left( res(i) - lsp_{res}^{(l2)}(i) \right)^2 \qquad \cdots (3)$$

After obtaining squared errors $er_2$ for all 12 indexes, LSP quantizing section 603 then determines 12 values that minimize squared error $er_2$ ($12_{min}$). Then, LSP quantizing section 603 outputs $12_{min}$ as the second quantized LSP code (L2) to multiplex section 614.

Then, LSP quantizing section 603 obtains second quantized LSP $lsp_2$ (i) by equation (4).

$$lsp_2(i) = lsp_1^{(l1_{\min})}(i) + lsp_{res}^{(l2_{\min})}(i) \quad (i = 0, \cdots, N-1) \qquad \cdots (4)$$

Then, LSP quantizing section 603 outputs the second quantized LSP $lsp_2$(i) to synthesis filter 604.

$lsp_2$(i) obtained by LSP quantizing section 603, is the "second quantized LSP", and $lsp_{res}^{(12min)}$ (i) that minimizes squared error $er_2$ is the "quantized residual LSP".

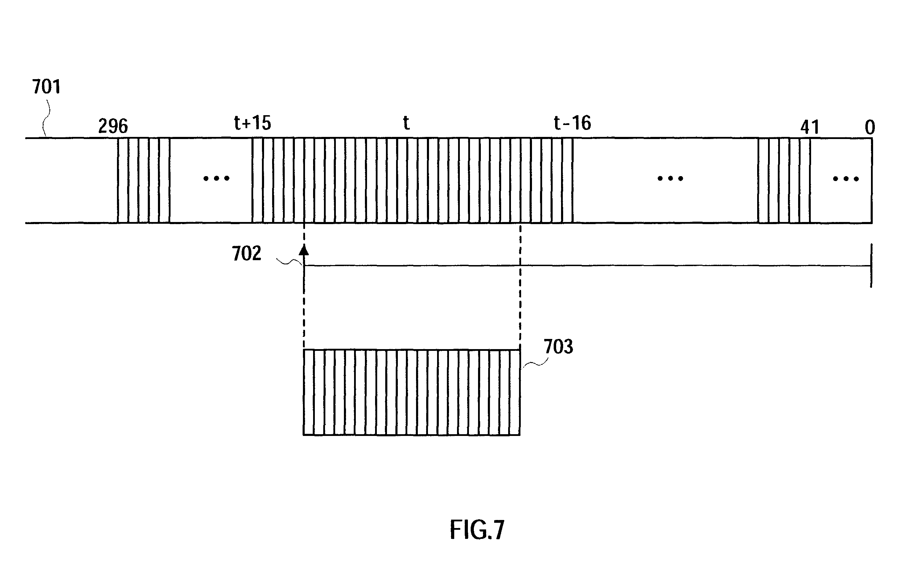

Next, processing in which parameter determination section 613 determines the second adaptive excitation lag will be described using FIG.7. In FIG.7, buffer 301 is the buffer that adaptive excitation codebook 606 provides, position 702 is a second adaptive excitation vector extraction position, vector 703 is an extracted second adaptive excitation vector. "t" is a first adaptive excitation lag, and values "41" and "296" correspond to lower and upper limits of the range with which parameter determination section 613 searches for the first adaptive excitation lag. "t - 16" and "t + 15" correspond to lower and upper limits of the range of shifting the second adaptive excitation vector extraction position.

Assuming that "5" bits are assigned to the code (A2) that represents the second adaptive excitation lag, the range of shifting extraction position 702 can be set to a range of length of "32" (for example, t - 16 to t + 15). Additionally, the range of shifting extraction position 702 can be arbitrarily set.

Parameter determination section 613 receives the first adaptive excitation lag "t" from first local decoding section 102 and sets the range of shifting extraction position 702 from t - 16 to t + 15. Then, parameter determination section 613 shifts extraction position 702 within the set range and sequentially indicates extraction position 702 to adaptive excitation codebook 606. Then, adaptive excitation codebook 606 extracts second adaptive excitation vector 303 with a length of the frame by extraction position 702 indicated by parameter determination section 613 and outputs the extracted second adaptive excitation vector to multiplier 609. Then, parameter determination section 613 obtains the coding distortion which is outputted from auditory weighting section 612 for the case of extracting second adaptive excitation vectors 303 at all extraction positions 702 and determines extraction position 702 that minimizes the coding distortion.

When extraction position 702 of the buffer obtained by parameter determination 613 is t +γ, γ(γ is anyvalue from-16 to 15) is the "second adaptive excitation lag". Accordingly, for extraction of second adaptive excitation vector 703 at second decoding section 154, second adaptive excitation lag 703 is extracted by adding first adaptive excitation lag t and second adaptive excitation lag γ and supplying addition result t+γ as extraction position 702.

Then, parameter determination section 613 outputs the second adaptive excitation lag code (A2) that represents the second adaptive excitation lag to multiplex section 614.

Also, parameter determination section 613 determines the second fixed excitation vector code (F2) in the same manner of processing in which parameter determination section 213 determines the first fixed excitation vector code (F1).

Moreover, parameter determination section 613 determines the second quantized excitation gain code (G2) in the same manner of processing in which parameter determination section 213 determines the first quantized excitation gain code (G1).

Next, a processing in which decision section 105 generates flag information will be described. Decision section 105 receives the first LSP from first encoding section 101, the first quantized LSP from first local decoding section 102, and the quantized residual LSP from second encoding section 104. Decision section 105 is provided with a buffer inside to store a first quantized LSP in the preceding frame.

Then, decision section 105 obtains squared error $er_3$ between the first LSP and the first quantized LSP in the preceding frame by equation (5).

$$er_3 = \sum_{i=0}^{N-1} \left( \alpha_1(i) - lsp_{pre1}(i) \right)^2 \qquad \cdot \cdot \cdot (5)$$

where, $\alpha(i)$ is the first LSP and $lsp_{pre1}(i)$ is the first quantized LSP in the preceding frame stored in the buffer.

Then, decision section 105 obtains squared error er4 between the first LSP and a vector as the sum of the first quantized LSP in the preceding frame and the quantized residual LSP.

$$er_4 = \sum_{i=0}^{N-1} \left( \alpha_1(i) - \left( lsp_{pre1}(i) + lsp_{res}(i) \right) \right)^2 \qquad \cdot \cdot \cdot (6)$$

where, $lsp_{res}(i)$ is the quantized residual LSP.

Then, decision section 105 compares squared error $er_3$ with squared error $er_4$ in terms of magnitude. If squared error $er_3$ is smaller, the flag takes a value of "0", and, if squared error $er_4$ is smaller, the flag takes a value of "1". Then, the decision section 105 outputs the flag information to the multiplex section 106. Then, decision section 105 stores the first quantized LSP inputted from first local decoding section 102, thus updating the buffer. The thus stored first quantized LSP is used as the first quantized LSP in the preceding frame for the next frame.

By thus comparing the case of using the first encoded information in the preceding frame and another case of using both the first encoded information in the preceding frame and the quantized residual LSP and by transmitting information indicating which case can produce a value closer to the first LSP to the decoding apparatus side as the flag information, it canbe indicated whether the first decoding section should decode using only the first encoded information in the preceding frame or decode using both the first encoded information in the preceding frame and the quantized residual LSP if a first encoded information loss is detected at the decoding apparatus side.

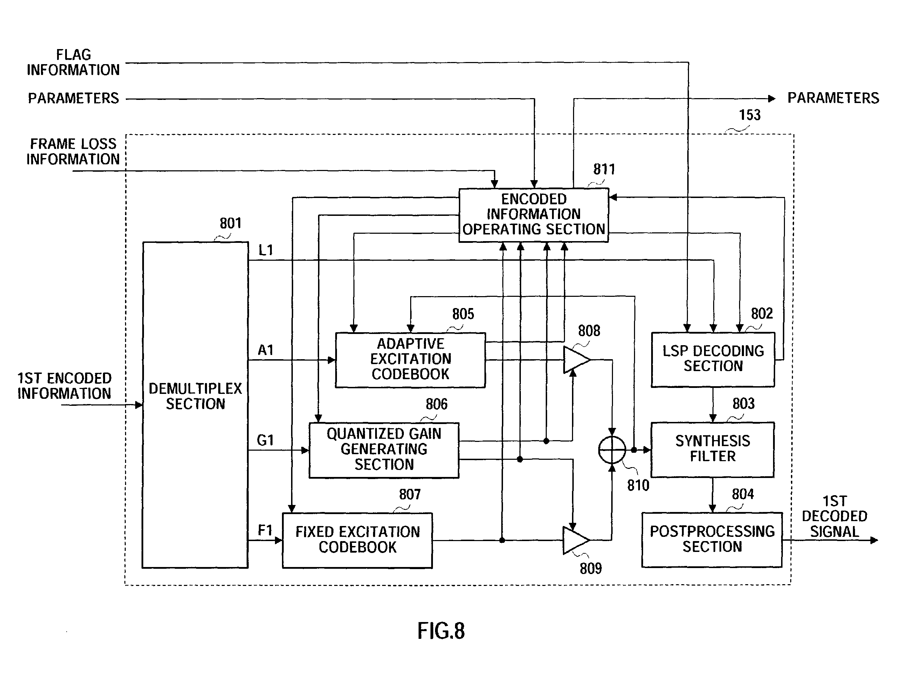

Next, an internal structure of first decoding section 153 will be described, using the block diagram shown in FIG.8. In FIG.8, if first encoded information is transmitted without loss, first encoded information inputted to first decoding section 153 is demultiplexed into individual codes (L1, A1, G1, F1) by demultiplex section 801. The first quantized LSP code (L1) demultiplexed from the first encoded information is outputted to LSP decoding section 802; the first adaptive excitation lag code (A1) demultiplexed as well is outputted to adaptive excitation codebook 805; the first quantized excitation gain code (G1) demultiplexed as well is outputted to quantized gain generating section 806; and the first fixed excitation vector code (F1) demultiplexed as well is outputted to fixed excitation codebook 807.

LSP decoding section 802 receives flag information from demultiplex section 151 and frame loss information from encoded information operating section 811. If the frame loss information is "1" or "3", LSP decoding section 802 receives the first quantized LSP code (L1) from demultiplex section 801 and decodes the first quantized LSP code (L1) into the first quantized LSP. If the frame loss information is "0", LSP decoding section 802 receives the first quantized LSP in the preceding frame from encoded information operating section 811 and supplies it as the first quantized LSP. If the frame loss information is "2", LSP decoding section 802 receives the first quantized LSP in the preceding frame and the quantized residual LSP from encoded information operating section 811, adds these LSPs, and supplies the first quantized LSP resulting from the addition. However, LSP decoding section 802 does not use the quantized residual LSP, if the flag information is "0". Then, LSP decoding section 802 outputs said first quantized LSP to synthesis filter 803 and encoded information operating section 811. The first quantized LSP outputted to encoded information operating section 811 is used as the first quantized LSP in the preceding frame, when decoding for the next frame is executed.

Adaptive excitation codebook 805 has a buffer storing driving excitations which have so far been outputted by adder 810. Adaptive excitation codebook 805 receives frame loss information from encoded information operating section 811. If the frame loss information is "1" or "3", adaptive excitation codebook 805 receives the first adaptive excitation lag code (A1) from demultiplex section 801, extracts a set of samples for one frame from the buffer at an extraction position specified by the first adaptive excitation lag code (A1), and supplies the thus extracted vector as a first adaptive excitation vector. If the frame loss information is "0", adaptive excitation codebook 805 receives the first adaptive excitation lag in the preceding frame from encoded information operating section 811, extracts a set of samples for one frame from the buffer at an extraction position specified by the first adaptive excitation lag in the preceding frame, and supplies the thus extracted vector as a first adaptive excitation vector. If the frame loss information is "2", adaptive excitation codebook 805 receives the first adaptive excitation lag in the preceding frame and the second adaptive excitation lag from the encoded information operating section 81, extracts a set of samples for one frame from the buffer at an extraction position specified by a result of the addition of these lags, and supplies the thus extracted vector as a first adaptive excitation vector.

Then, adaptive excitation codebook 805 outputs the first adaptive excitation vector to multiplier 808. Also, adaptive excitation codebook 805 outputs the first adaptive excitation vector extraction position as a first adaptive excitation lag to encoded information operating section 811. The first adaptive excitation lag outputted to encoded information operating section 811 is used as the first adaptive excitation lag in the preceding frame, when decoding for the next frame is executed. Moreover, adaptive excitation codebook 805 updates the buffer, each time a driving excitation is inputted thereto from adder 810.

Quantized gain generating section 806 receives frame loss information from encoded information operating section 811. If the frame loss information is "1" or "3", quantized gain generating section 806 receives the first quantized excitation gain code (G1) from demultiplex section 801 and decodes to obtain the first quantized adaptive excitation gain and the first quantized fixed excitation gain which are specified by the first quantized excitation gain code (G1). If the frame loss information is "0", quantized gain generating section 806 receives the first quantized adaptive excitation gain in the preceding frame and the first quantized fixed excitation gain in the preceding frame from encoded information operating section 811 and supplies these gains as the first quantized adaptive excitation gain and the first quantized fixed excitation gain. If the frame loss information is "2", quantized gain generating section 806 receives the first quantized adaptive excitation gain in the preceding frame, the first quantized fixed excitation gain in the preceding frame, the second quantized adaptive excitation gain, and the second quantized fixed excitation gain from encoded information operating section 811. Then, quantized gain generating section 806 adds the first quantized adaptive excitation gain in the preceding frame and the second quantized adaptive excitation gain, multiplies a result of the addition by 0.5, and supplies the multiplication result as the first quantized adaptive excitation gain. Also, quantized gain generating section 806 adds the first quantized fixed excitation gain in the preceding frame and the second quantized fixed excitation gain, multiplies the addition result by 0.5, and supplies the multiplication result as the first quantized fixed excitation gain. Then, quantized gain generating section 806 outputs the first quantized adaptive excitation gain to multiplier 808 and encoded information operating section 811 and outputs the first quantized fixed excitation gain to multiplier 809 and encoded information operating section 811. The first quantized adaptive excitation gain and the first quantized fixed excitation gain outputted to encoded information operating section 811 are used as the first quantized adaptive excitation gain in the preceding frame and the first quantized fixed excitation gain in the preceding frame, when decoding processing for the next frame is executed.

Fixed excitation codebook 807 receives frame loss information from encoded information operating section 811. If the frame information is "1" or "3", fixed excitation codebook 807 receives the first fixed excitation vector code (F1) from demultiplex section 801 and generates the first fixed excitation vector specified by the first fixed excitation vector code (F1). If the frame information is "0" or "2", fixed excitation codebook 807 receives the first fixed excitation vector in the preceding frame from encoded information operating section 811 and supplies this vector as the first fixed excitation vector. Then, fixed excitation codebook 807 outputs the first fixed excitation vector to multiplier 809 and encoded information operating section 811. The first fixed excitation vector outputted to encoded information operating section 811 is used as the first fixed excitation vector in the preceding frame, when decoding processing for the next frame is executed.

Multiplier 808 multiplies the first adaptive excitation vector by the first quantized adaptive excitation gain and outputs the result to adder 810. Multiplier 809 multiplies the first fixed excitation vector by the first quantized fixed excitation gain and outputs the result to adder 810.

Adder 810 adds the first adaptive excitation vector and the first fixed excitation vector multiplied by the respective gains, outputted from multipliers 808 and 809, thus generates a driving excitation, and outputs the driving excitation to synthesis filter 803 and adaptive excitation codebook 805.

Synthesis filter 803 performs filter synthesis on the driving excitation outputted from adder 810 with the filter coefficient decoded by LSP decoding section 802 and outputs a synthesis signal to postprocessing section 804.

Postprocessing section 804 processes the synthesis signal outputted from synthesis filter 803 by processing for improving a subjective speech quality, such as formant emphasizing and pitch emphasizing, and by processing for improving a subjective stationary noise quality, and outputs the processed signal as a first decoded signal.

Encoded information operating section 811 is provided with a buffer inside to store various parameters. In the buffer, the first quantized LSP obtained in the preceding frame (first quantized LSP in the preceding frame), the first adaptive excitation lag obtained in the preceding frame (first adaptive excitation lag in the preceding frame), the first quantized adaptive excitation gain obtained in the preceding frame (first quantized adaptive excitation gain in the preceding frame), the first quantized fixed excitation gain obtained in the preceding frame (first quantized fixed excitation gain in the preceding), and the first fixed excitation vector obtained in the preceding frame (first fixed excitation vector in the preceding frame) are stored.

Encoded information operating section 811 receives frame loss information from frame loss detecting section 152.

If the frame loss information is "2", then encoded information operating section 811 receives the quantized residual LSP, the second adaptive excitation lag, the second quantized adaptive excitation gain, and the second quantized fixed excitation gain from second decoding section 154. Then, encoded information operating section 811 outputs the frame loss information to LSP decoding section 802, adaptive excitation codebook 805, quantized gain generating section 806 and fixed excitation codebook 807. If the frame loss information is "0", encoded information operating section 811 outputs the first quantized LSP in the preceding frame to LSP decoding section 802, the first adaptive excitation lag in the preceding frame to adaptive excitation codebook 805, the first quantized adaptive excitation gain in the preceding frame and the first quantized fixed excitation gain in the preceding frame to quantized gain generating section 806, and the first fixed excitation vector in the preceding frame to fixed excitation codebook 807. If the frame loss information is "2", encoded information operating section 811 outputs the first quantized LSP in the preceding frame and the quantized residual LSP to LSP decoding section 802, the first adaptive excitation lag in the preceding frame and the second adaptive excitation lag to adaptive excitation codebook 805, the first quantized adaptive excitation gain in the preceding frame, the first quantized fixed excitation gain in the preceding frame, the second quantized adaptive excitation gain, and the second quantized fixed excitation gain to quantized gain generating section 806, and the first fixed excitation vector to fixed excitation codebook 807.

Then, encoded information operating section 811 receives the first quantized LSP used in decoding for the current frame from LSP decoding section 802, the first adaptive excitation lag from adaptive excitation codebook 805, the first quantized adaptive excitation gain and the first quantized fixed excitation gain from quantized gain generating section 806, and the first fixed excitation vector from fixed excitation codebook 807. If the frame information is "1" or "3", then encoded information operating section 811 outputs the first quantized LSP, the first adaptive excitation lag, the first quantized adaptive excitation gain, and the first quantized fixed excitation gain to second decoding section 154. If the frame loss information is "0" or "2", encoded information operating section 811 outputs the first quantized LSP in the preceding frame and the first adaptive excitation lag in the preceding frame, stored in the buffer, to second decoding section 154.

Upon completion of the above processing, encoded information operating section 811 stores the first quantized LSP, the first adaptive excitation lag, the first quantized adaptive excitation gain, the first quantized fixed excitation gain, and the first fixed excitation vector, which are applied in decoding for the current frame, into the buffer, as the first quantized LSP in the preceding frame, the first adaptive excitation lag in the preceding frame, the first quantized adaptive excitation gain in the preceding frame, the first quantized fixed excitation gain in the preceding frame, and the first fixed excitation vector in the preceding frame, thus updating the buffer.

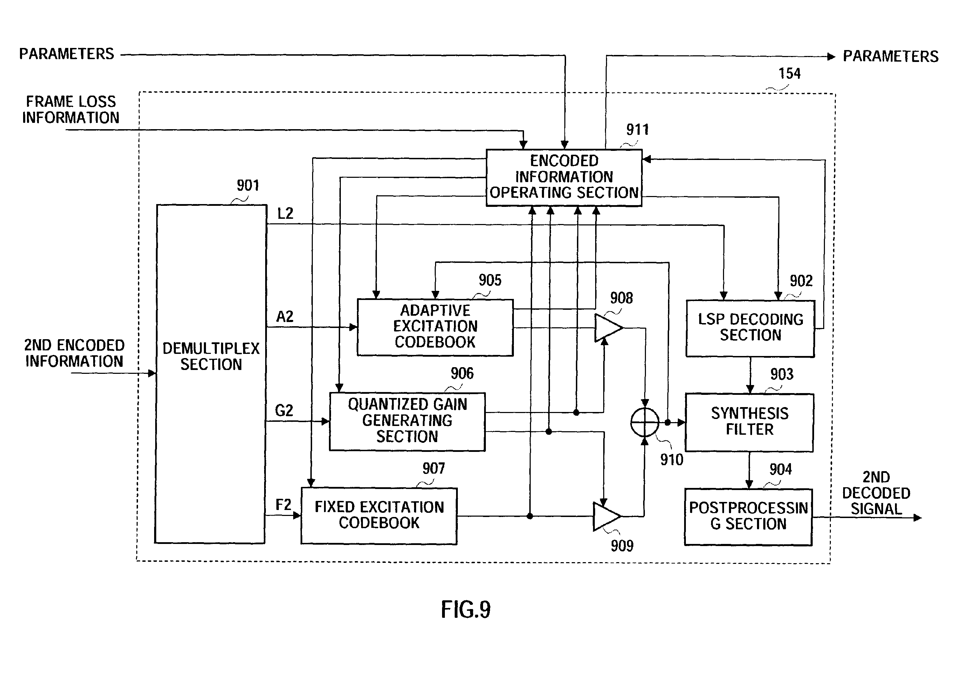

Next, an internal configuration of second decoding section 154 will be described, using the block diagram shown in FIG.9. In FIG.9, if second encoded information is transmitted without loss, the second encoded information inputted to second decoding section 153 is demultiplexed into individual codes (L2, A2, G2 and F2) by demultiplex section 901. The second quantized LSP code (L2) demultiplexed from the second encoded information is outputted to LSP decoding section 902; the second adaptive excitation lag code (A2) demultiplexed as well is outputted to adaptive excitation codebook 905; the second quantized excitation gain code (G2) demultiplexed as well is outputted to quantized gain generating section 906; and the second fixed excitation vector code (F2) demultiplexed as well is outputted to fixed excitation codebook 907.

LSP decoding section 902 receives frame loss information from encoded information operating section 911. If the frame loss information is "3", LSP decoding section 902 receives the first quantized LSP from encoded information operating section 911 and the second quantized LSP code (L2) from demultiplex section 901, decodes the second quantized LSP code (L2) into quantized residual LSP, adds the first quantized LSP and the quantized residual LSP, and supplies the addition result as second quantized LSP. If the frame loss information is "1", LSP decoding section 902 receives the first quantized LSP and the quantized residual LSP in the preceding frame from encoded information operating section 911, adds the first quantized LSP and the quantized residual LSP in the preceding frame, and supplies the addition result as second quantized LSP. If the frame loss information is "2", LSP decoding section 902 receives the first quantized LSP in the preceding frame from encoded information operating section 911 and the second quantized LSP code (L2) from demultiplex section 901, decodes the second quantized LSP code (L2) into quantized residual LSP, adds the first quantized LSP in the preceding frame and the quantized residual LSP, and supplies the addition result as second quantized LSP. If the frame loss information is "0", LSP decoding section 902 receives the first quantized LSP in the preceding frame and the quantized residual LSP in the preceding frame from encoded information operating section 911, adds the first quantized LSP in the preceding frame and the quantized residual LSP in the preceding frame, and supplies the addition result as second quantized LSP.

Then, LSP decoding section 902 outputs the second quantized LSP to synthesis filter 903. If the frame loss information is "2" or "3", then LSP decoding section 902 outputs the quantized residual LSP obtained by decoding the second quantized LSP code (L2) to encoded information operating section 911. If the frame loss information is "0" or "1", LSP decoding section 902 outputs the quantized residual LSP in the preceding frame to encoded information operating section 911. The quantized residual LSP or the quantized residual LSP in the preceding frame outputted to encoded information operating section 911 is used as the quantized residual LSP in the preceding frame, when decoding processing for the next frame is executed.

Adaptive excitation codebook 905 has a buffer storing driving excitations which have so far been outputted by adder 910. Adaptive excitation codebook 905 receives frame loss information from encoded information operating section 911.

If the frame loss information is "3", adaptive excitation codebook 905 receives the first adaptive excitation lag from encoded information operating section 911 and the second adaptive excitation lag code (A2) from demultiplex section 901, adds the first adaptive excitation lag and the second adaptive excitation lag code (A2), extracts a set of samples for one frame from the buffer at an extraction position specified by the addition result, and supplies the thus extracted vector as a second adaptive excitation vector. If the frame loss information is "1", adaptive excitation codebook 905 receives the first adaptive excitation lag and the second adaptive excitation lag in the preceding frame from encoded information operating section 911, adds these adaptive excitation lags, extracts a set of samples for one frame from the buffer at an extraction position specified by the addition result, and supplies the thus extracted vector as a second adaptive excitation vector. If the frame loss information is "2", adaptive excitation codebook 905 receives the first adaptive excitation lag in the preceding frame from encoded information operating section 911 and the second adaptive excitation lag code (A2) from demultiplex section 901, adds the first adaptive excitation lag in the preceding frame and the second adaptive excitation lag code (A2), extracts a set of samples for one frame from the buffer at an extraction position specified by the addition result, and supplies the thus extracted vector as a second adaptive excitation vector. If the frame loss information is "0", adaptive excitation codebook 905 receives the first adaptive excitation lag in the preceding frame and the second adaptive excitation lag in the preceding frame from encoded information operating section 911, adds these adaptive excitation lags, and extracts a set of samples for one frame from the buffer at an extraction position specified by the addition result, and supplies the thus extracted vector as a second adaptive excitation vector.

Then, adaptive excitation codebook 905 outputs the second adaptive excitation vector to multiplier 908. Also, adaptive excitation codebook 905 outputs the second adaptive excitation lag code (A2) as the second adaptive excitation lag to encoded information operating section 911, if the frame loss information is "2" or "3"; it outputs the second adaptive excitation lag in the preceding frame to encoded information operating section 911, if the frame loss information is "0" or "1". The second adaptive excitation lag or the second adaptive excitation lag in the preceding frame outputted to encoded information operating section 911 is used as the second adaptive excitation lag in the preceding frame, when decoding processing for the next frame is executed. Moreover, adaptive excitation codebook 905 updates the buffer, each time a driving excitation is inputted thereto from adder 910.

Quantized gain generating section 906 receives frame loss information from encoded information operating section 911. If the frame loss information is "2" or "3", quantized gain generating section 906 receives the second quantized excitation gain code (G2) from demultiplex section 901 and decodes to obtain the second quantized adaptive excitation gain and the second quantized fixed excitation gain which are specified by the second quantized excitation gain code (G2). If the frame loss information is "1", quantized gain generating section 906 receives the first quantized adaptive excitation gain, the first quantized fixed excitation gain, the second quantized adaptive excitation gain in the preceding frame, and the second quantized fixed excitation gain in the preceding frame from encoded information operating section 911. Then, quantized gain generating section 906 adds the first quantized adaptive excitation gain and the second quantized adaptive excitation gain in the preceding frame, multiplies the addition result by 0.5, and supplies the multiplication result as the second quantized adaptive excitation gain. Also, quantized gain generating section 906 adds the first quantized fixed excitation gain and the second quantized fixed excitation gain in the preceding frame, multiplies the addition result by 0.5, and supplies the multiplication result as the second quantized adaptive excitation gain. If the frame loss information is "0", quantized gain generating section 906 receives the second quantized adaptive excitation gain in the preceding frame and the second quantized fixed excitation gain in the preceding frame from encoded information operating section 911 and supplies these gains as the second quantized adaptive excitation gain and the second quantized fixed excitation gain.

Then, quantized gain generating section 906 outputs the second quantized adaptive excitation gain to multiplier 908 and encoded information operating section 911 and outputs the second quantized fixed excitation gain to multiplier 909 and encoded information operating section 911. The second quantized adaptive excitation gain and the second quantized fixed excitation gain outputted to encoded information operating section 911 are used as the second quantized adaptive excitation gain in the preceding frame and the second quantized fixed excitation gain in the preceding frame, when decoding processing for the next frame is executed.

Fixed excitation codebook 907 receives frame loss information from encoded information operating section 911. If the frame information is "2" or "3", fixed excitation codebook 907 receives the second fixed excitation vector code (F2) from demultiplex section 901 and generates the second fixed excitation vector specified by the second fixed excitation vector code (F2). If the frame information is "0" or "1", fixed excitation codebook 907 receives the second fixed excitation vector in the preceding frame from encoded information operating section 911 and supplies this vector as the second fixed excitation vector. Then, fixed excitation codebook 907 outputs the second fixed excitation vector to multiplier 909 and encoded information operating section 911. The second fixed excitation vector outputted to encoded information operating section 911 is used as the second fixed excitation vector in the preceding frame, when decoding processing for the next frame is executed.

Multiplier 908 multiples the second adaptive excitation vector by the second quantized adaptive excitation gain and outputs the result to adder 910. Multiplier 909 multiples the second fixed excitation vector by the second quantized fixed excitation gain and outputs the result to adder 910.

Adder 910 adds the second adaptive excitation vector and the second fixed excitation vector multiplied by the respective gains, outputted from multipliers 908 and 909, thus generates a driving excitation, and outputs the driving excitation to synthesis filter 903 and adaptive excitation codebook 905.

Synthesis filter 903 performs filter synthesis on the driving excitation outputted from adder 910 with the filter coefficient decoded by LSP decoding section 902 and outputs a synthesis signal to postprocessing section 904.

Postprocessing section 904 processes the synthesis signal outputted from synthesis filter 903 by processing for improving a subjective speech quality, such as formant emphasizing and pitch emphasizing, and by processing for improving a subjective stationary noise quality, and outputs the processed signal as a second decoded signal.

Encoded information operating section 911 is provided with a buffer inside to store various parameters. In the buffer, the quantized residual LSP obtained in the preceding frame (quantized residual LSP in the preceding frame), the second adaptive excitation lag obtained in the preceding frame (second adaptive excitation lag in the preceding frame), the second quantized adaptive excitation gain obtained in the preceding frame (second quantized adaptive excitation gain in the preceding frame), the second quantized fixed excitation gain obtained in the preceding frame (second quantized fixed excitation gain in the preceding), and the second fixed excitation vector obtained in the preceding frame (second fixed excitation vector in the preceding frame) are stored.

Encoded information operating section 911 receives frame loss information from frame loss detecting section 152. If the frame loss information is "1" or "3", encoded information operating section 911 receives the first quantized LSP, the first adaptive excitation lag, the first quantized adaptive excitation gain, and the first quantized fixed excitation gain from first decoding section 153. If the frame loss information is "0" or "2", encoded information operating section 911 receives the first quantized LSP in the preceding frame and the first adaptive excitation lag in the preceding frame from first decoding section 153. Then, encoded information operating section 911 outputs the frame loss information to LSP decoding section 902, adaptive excitation codebook 905, quantized gain generating section 906 and fixed excitation codebook 907. If the frame loss information is "0", encoded information operating section 911 outputs the first quantized LSP in the preceding frame and the quantized residual LSP in the preceding frame to LSP decoding section 902, the first adaptive excitation lag in the preceding frame and the second adaptive excitation lag in the preceding frame to adaptive excitation codebook 905, the second quantized adaptive excitation gain in the preceding frame and the second quantized fixed excitation gain in the preceding frame to quantized gain generating section 906, and the second fixed excitation vector in the preceding frame to fixed excitation codebook 907. If the frame loss information is "1", encoded information operating section 911 outputs the first quantized LSP and the quantized residual LSP in the preceding frame to LSP decoding section 902, the first adaptive excitation lag and the second adaptive excitation lag in the preceding frame to adaptive excitation codebook 905, the first quantized adaptive excitation gain, the first quantized fixed excitation gain, the second quantized adaptive excitation gain in the preceding frame, and the second quantized fixed excitation gain in the preceding frame to quantized gain generating section 906, and the second fixed excitation vector in the preceding frame to fixed excitation codebook 907. If the frame loss information is "2", encoded information operating section 911 outputs the first quantized LSP in the preceding frame to LSP decoding section 902 and the first adaptive excitation lag in the preceding frame to adaptive excitation codebook 905. If the frame loss information is "3", encoded information operating section 911 outputs the first quantized LSP to LSP decoding section 902 and the first adaptive excitation lag to adaptive excitation codebook 905.

Then, encoded information operating section 911 receives the quantized residual LSP used in decoding for the current frame from LSP decoding section 902, the second adaptive excitation lag from adaptive excitation codebook 905, the second quantized adaptive excitation gain and the second quantized fixed excitation gain from quantized gain generating section 906, and the second fixed excitation vector from fixed excitation codebook 907. Then, encoded information operating section 911 outputs the quantized residual LSP, the second adaptive excitation lag, the second quantized adaptive excitation gain, and the second quantized fixed excitation gain to first decoding section 153, if the frame loss information is "2".

Upon completion of the above processing, encoded information operating section 911 stores the quantized residual LSP, the second adaptive excitation lag, the second quantized adaptive excitation gain, the second quantized fixed excitation gain, and the second fixed excitation vector, which are used in decoding for the current frame, into the buffer, as the quantized residual LSP in the preceding frame, the second adaptive excitation lag in the preceding frame, the second quantized adaptive excitation gain in the preceding frame, the second quantized fixed excitation gain in the preceding frame, and the second fixed excitation vector in the preceding frame, thus updating the buffer.

In first decoding section 153 and second decoding section 154, as described above, by selecting appropriate parameters for use in decoding from among the first encoded information, second encoded information, first encoded information in the preceding frame, and second encoded information in the preceding frame, according to frame loss information, it is possible to perform decoding suited for encoded information loss state and obtain decoded signals with good quality.

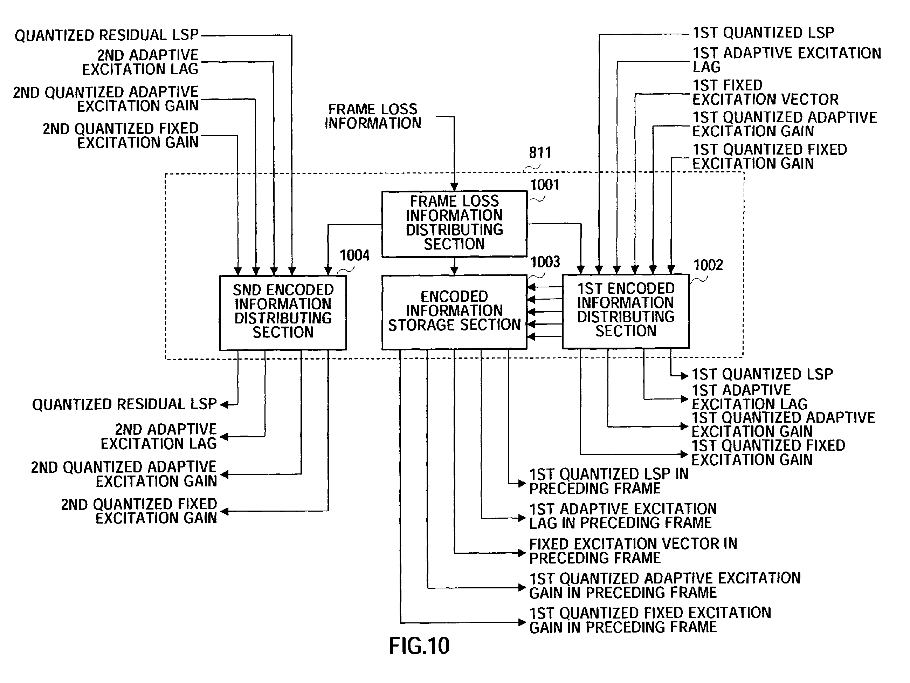

Next, an internal configuration of encoded information operating section 811 will be described, using the block diagram shown in FIG.10. Frame loss information distributing section 1001 receives frame loss information from frame loss detecting section 152 and outputs this information to first encoded information distributing section 1002, encoded information storage section 1003, second encoded information distributing section 1004, LSP decoding section 802, adaptive excitation codebook 805, quantized gain generating section 806 and fixed excitation codebook 807.

First encoded information distributing section 1002 receives frame loss information from frame loss information distributing section 1001. Then, first encoded information distributing section 1002 receives the first quantized LSP from LSP decoding section 802, the first adaptive excitation lag from adaptive excitation codebook 805, the first quantized adaptive excitation gain and the first quantized fixed excitation gain from quantized gain generating section 806, and the first fixed excitation vector from fixed excitation codebook 807. Then, first encoded information distributing section 1002 outputs the first quantized LSP, the first adaptive excitation lag, the first fixed excitation vector, the first quantized adaptive excitation gain, and the first quantized fixed excitation gain to encoded information storage section 1003. If the frame loss information is "1" or "3", then first encoded information distributing section 1002 outputs the first quantized LSP, the first adaptive excitation lag, the first fixed excitation vector, the first quantized adaptive excitation gain and the first quantized fixed excitation gain to second decoding section 154.

Encoded information storage section 1003 receives frame loss information from frame loss information distributing section 1001. Encoded information storage section 1003 is provided with a buffer inside to store the first quantized LSP, first adaptive excitation lag, first fixed excitation vector, first quantized adaptive excitation gain and first quantized fixed excitation gain in the preceding frame. If the frame loss information is "0" or "2", then encoded information storage section 1003 outputs the first quantized LSP in the preceding frame to LSP decoding section 802, the first adaptive excitation lag in the preceding frame to adaptive excitation codebook 805, the first fixed excitation vector in the preceding frame to fixed excitation codebook 807, and the first quantized adaptive excitation gain in the preceding frame and the first quantized fixed excitation gain in the preceding frame to quantized gain generating section 806. If the frame loss information is "0" or "2", moreover, encoded information storage section 1003 outputs the first quantized LSP in the preceding frame and the first adaptive excitation lag in the preceding frame to second decoding section 154. Then, encoded information storage section 1003 receives the first quantized LSP, first adaptive excitation lag, first fixed excitation vector, first quantized adaptive excitation gain and first quantized fixed excitation gain from first encoded information distributing section 1002. Then, encoded information storage section 1003 stores the first quantized LSP, first adaptive excitation lag, first fixed excitation vector, first quantized adaptive excitation gain, and first quantized fixed excitation gain into the buffer, thus updating the buffer. The thus stored first quantized LSP, first adaptive excitation lag, first fixed excitation vector, first quantized adaptive excitation gain and first quantized fixed excitation gain are used for the next frame as the first quantized LSP in the preceding frame, the first adaptive excitation lag in the preceding frame, the first fixed excitation vector in the preceding frame, the first quantized adaptive excitation gain in the preceding frame and the first quantized fixed excitation gain in the preceding frame.

Second encoded information distributing section 1004 receives frame loss information from frame loss information distributing section 1001. If the frame loss information is "2", then second encoded information distributing section 1004 receives the quantized residual LSP, the second adaptive excitation lag, the second quantized adaptive excitation gain, and the second quantized fixed excitation gain from second decoding section 154. If the frame loss information is "2", then second encoded information distributing section 1004 outputs the quantized residual LSP to LSP decoding section 802, the second adaptive excitation lag to adaptive excitation codebook 805, and the second quantized adaptive excitation gain and the second quantized fixed excitation gain to quantized gain generating section 806.

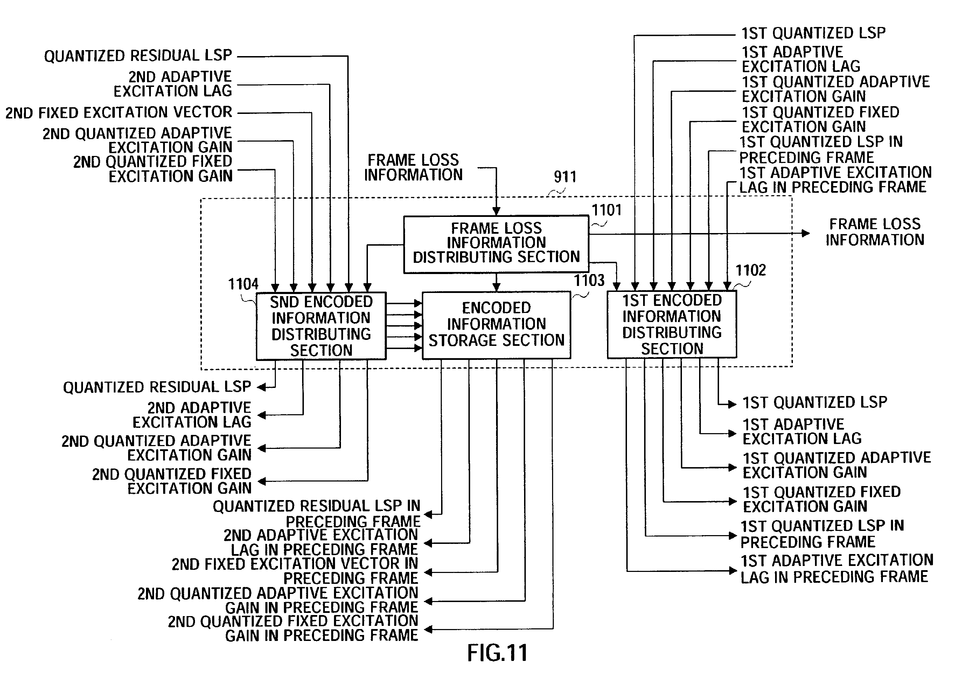

Next, an internal configuration of encoded information operating section 911 will be described, using the block diagram shown in FIG.11. Frame loss information distributing section 1101 receives frame loss information from frame loss detecting section 152 and outputs this information to first encoded information distributing section 1102, encoded information storage section 1103, second encoded information distributing section 1104, LSP decoding section 902, adaptive excitation codebook 905, quantized gain generating section 906 and fixed excitation codebook 907.

First encoded information distributing section 1102 receives frame loss information from frame loss information distributing section 1101. If the frame loss information is "1" or "3", then first encoded information distributing section 1102 receives the first quantized LSP, first adaptive excitation lag, first quantized adaptive excitation gain and first quantized fixed excitation gain from first decoding section 153. If the frame loss information "0" or "2", first encoded information distributing section 1102 receives the first quantized LSP in the preceding frame and the first adaptive excitation lag in the preceding frame from first decoding section 153. If the frame loss information is "1" or "3", then first encoded information distributing section 1102 outputs the first quantized LSP to LSP decoding section 902 and the first adaptive excitation lag to adaptive excitation codebook 905. If the frame loss information is "1", first encoded information distributing section 1102 outputs the first quantized adaptive excitation gain and the first quantized fixed excitation gain to quantized gain generating section 906. If the frame loss information is "0" or "2", first encoded information distributing section 1102 outputs the first quantized LSP in the preceding frame to the LSP decoding section 902 and the first adaptive excitation lag in the preceding frame to adaptive excitation codebook 905.

Second encoded information distributing section 1104 receives frame loss information from frame loss information distributing section 1101. Then, second encoded information distributing section 1104 receives the quantized residual LSP from LSP decoding section 902, the second adaptive excitation lag from adaptive excitation codebook 905, the second quantized adaptive excitation gain and the second quantized fixed excitation gain from quantized gain generating section 906, and the second fixed excitation vector from fixed excitation codebook 907. Then, second encoded information distributing section 1104 outputs the quantized residual LSP, second adaptive excitation lag, second fixed excitation vector, second quantized adaptive excitation gain and second quantized fixed excitation gain to encoded information storage section 1103. If the frame loss information is "2", then second encoded information distributing section 1104 outputs the quantized residual LSP, second adaptive excitation lag, second quantized adaptive excitation gain and second quantized fixed excitation gain to first decoding section 153.

Encoded information storage section 1103 receives frame loss information from frame loss information distributing section 1101. Encoded information storage section 1103 is provided with a buffer inside to store the quantized residual LSP, second adaptive excitation lag, second fixed excitation vector, second quantized adaptive excitation gain, and second quantized fixed excitation gain in the preceding frame. If the frame loss information is "0" or "1", then encoded information storage section 1103 outputs the quantized residual LSP in the preceding frame to LSP decoding section 902, the second adaptive excitation lag in the preceding frame to adaptive excitation codebook 905, the second fixed excitation vector in the preceding frame to fixed excitation codebook 907, and the second quantized adaptive excitation gain in the preceding frame and the second quantized fixed excitation gain in the preceding frame to quantized gain generating section 906. Then, encoded information storage section 1103 receives the quantized residual LSP, second adaptive excitation lag, second fixed excitation vector, second quantized adaptive excitation gain and second quantized fixed excitation gain from second encoded information distributing section 1104. Then, encoded information storage section 1103 stores the quantized residual LSP, second adaptive excitation lag, second fixed excitation vector, second quantized adaptive excitation gain and second quantized fixed excitation gain into the buffer, thus updating the buffer. The thus stored quantized residual LSP, second adaptive excitation lag, second fixed excitation vector, second quantized adaptive excitation gain and second quantized fixed excitation gain are used for the next frame as the quantized residual LSP in the preceding frame, the second adaptive excitation lag in the preceding frame, the second fixed excitation vector in the preceding frame, the second quantized adaptive excitation gain in the preceding frame and the second quantized fixed excitation gain in the preceding frame.

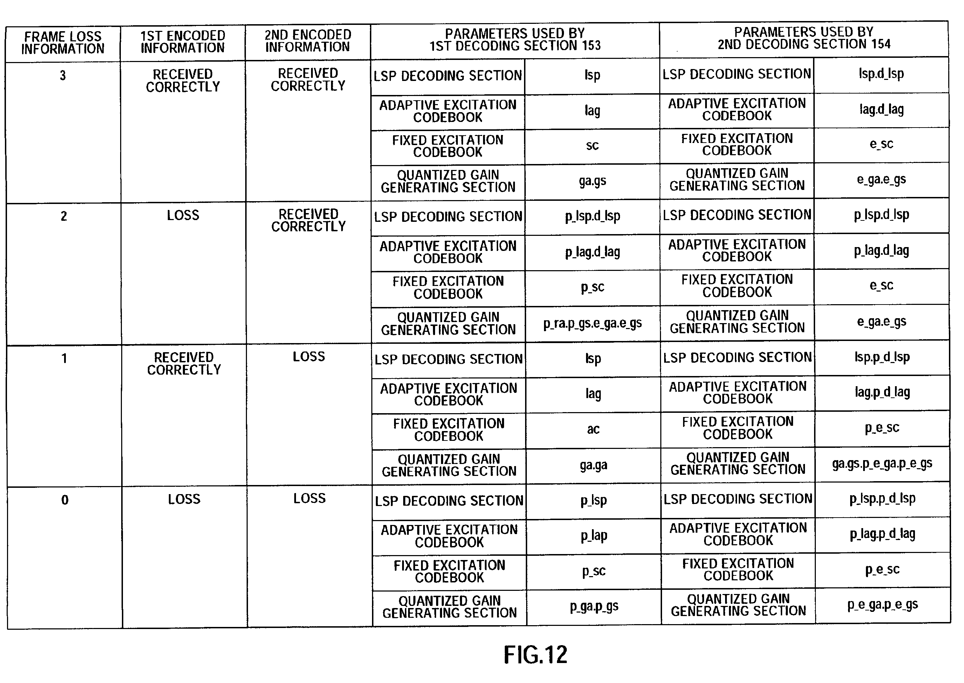

FIG.12 shows a table listing frame loss information and specific parameters to be used in decoding by first decoding section 153 and second decoding section 154, according to the frame loss information. The table also includes frame loss information values and associated states of first encoded information and second encoded information. In FIG.12, "lsp" stands for the first quantized LSP; "p_lsp" stands for the first quantized LSP in the preceding frame; "lag" stands for the first adaptive excitation lag; "p_lag" stands for the first adaptive excitation lag in the preceding frame; "sc" stands for the first fixed excitation vector; "p_sc" stands for the first fixed excitation vector in the preceding frame; "ga" stands for the first quantized adaptive excitation gain; "p_ga" stands for the first quantized adaptive excitation gain in the preceding frame; "gs" stands for the first quantized fixed excitation gain; "p_gs" stands for the first quantized fixed excitation gain in the preceding frame; "d_lsp" stands for the quantized residual LSP; "p_d_lsp" stands for the quantized residual LSP in the preceding frame; "d_lag" stands for the second adaptive excitation lag; "p_d_lag" stands for the second adaptive excitation lag in the preceding frame; "e_sc" stands for the second fixed excitation vector; "p_e_sc" stands for the second fixed excitation vector in the preceding frame; "e_ga" stands for the second quantized adaptive excitation gain; "p_e_ga" stands for the second quantized adaptive excitation gain in the preceding frame; "e_gs" stands for the second quantized fixed excitation gain; and "p_e_gs" stands for the second quantized fixed excitation gain in the preceding frame.

In FIG.12, "received correctly" means a state where encoded information is received correctly and "loss" means a state where data is not received correctly (is lost).

When the frame loss information is "3", both first encoded information and second encoded information are received correctly; therefore, first decoding section 153 and second decoding section 154 decode the received first encoded information and second encoded information. In short, normal decoding without taking frame loss in account is executed.

When the frame loss information is "2", first encoded information is not received correctly; therefore, first decoding section 153 and second decoding section 154 perform decoding using first encoded information in the preceding frame instead of the first encoded information. Also, first decoding section 153 decodes using the second encoded information in addition to the first encoded information in the preceding frame, so as to improve decoded signal quality.

When the frame loss information is "1", second encoded information is not received correctly; therefore, second decoding section 154 performs decoding using second encoded information in the preceding frame instead of the second encoded information.

When the frame loss information is "0", both first encoded information and second encoded information are not received correctly; therefore, first decoding section 153 and second decoding section 154 perform decoding using first encoded information and second encoded information in the preceding frame instead of the first encoded information and the second encoded information.

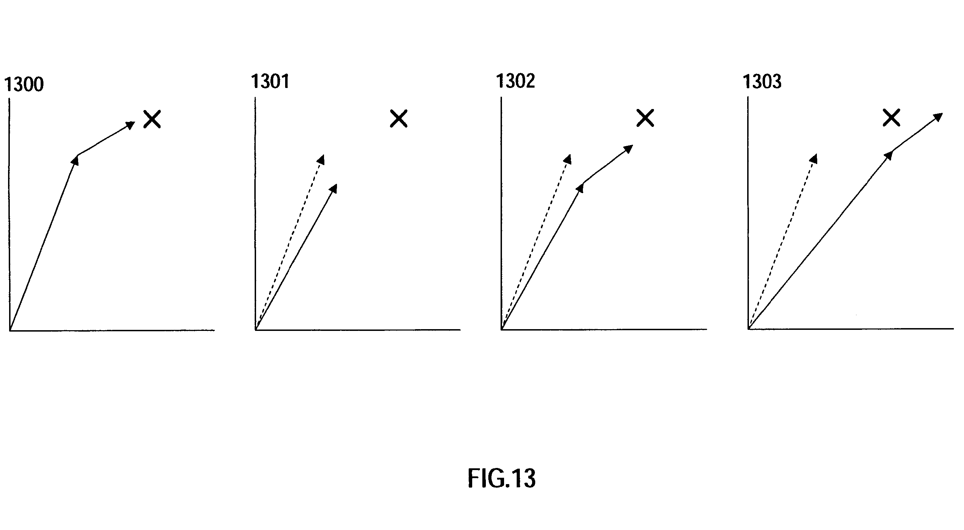

FIG. 13 visually explains that decoded signal quality can be improved by the fact that, if first encoded information is not received correctly, first decoding section 153 performs decoding using second encoded information in addition to first encoded information in the preceding frame.

Here, a case will be described as an example where LSP decoding section 802 in first decoding section 153 obtains first quantized LSP. To simplify the explanation, the first quantized LSP is assumed as two-dimensional vectors.

In FIG.13, a graph labeled with reference numeral 1300 is a pattern graph of first quantized LSP, quantized residual LSP and first LSP. Here, "x" indicates the first LSP, a long arrow indicates the first quantized LSP, and a short arrow indicates the quantized residual LSP. The first quantized LSP is included in first encoded information and the quantized residual LSP is included in second encoded information.

A graph labeled with reference numeral 1301 is a pattern graph of first quantized LSP, first quantized LSP in the preceding frame and first LSP. Here "x" indicates the first LSP, a dotted arrow indicates the first quantized LSP, and a solid arrow indicates the first quantized LSP in the preceding frame. This represents a case where first encoded information (first quantized LSP) is not received correctly and LSP decoding section 802 obtains the first quantized LSP using only the first quantized LSP in the preceding frame (using the first quantized LSP in the preceding frame instead of the lost first quantized LSP).

A graph labeled with reference numeral 1302 is a pattern graph of first quantized LSP, first quantized LSP in the preceding frame, quantized residual LSP and first LSP. Here, "x" indicates the first LSP, a dotted arrow indicates the first quantized LSP, a long solid arrow indicates the first quantized LSP in the preceding frame, and a short solid arrow indicates the quantized residual LSP. This represents a case where first encoded information (first quantized LSP) is not received correctly and LSP decoding section 802 adds the first quantized LSP in the preceding frame and the quantized residual LSP, and obtains the first quantized LSP resulting from the addition.

If there is a high correlation between the first quantized LSP and the first quantized LSP in the preceding frame, i.e., their differential is small, the first quantized LSP that is obtained by a manner using the first quantized LSP in the preceding frame and the quantized residual LSP (1302) becomes closer to the first LSP ("x") than the first quantized LSP that is obtained by a manner using only the first quantized LSP in the preceding frame (1301).

However, if the correlation between the first quantized LSP and the first quantized LSP in the preceding frame is low, i.e., their differential is large, it is not always true that the first quantized LSP that is obtained by a manner using the first quantized LSP in the preceding frame and the quantized residual LSP becomes closer to the first LSP ("x") (1303). With regard to both the manner using only the first quantized LSP in the preceding frame and the manner using the first quantized LSP in the preceding frame and the quantized residual LSP, an experiment was conducted in which first quantized LSPs are actually obtained per frame by each manner and compared in terms of that the first quantized LSP obtained by which manner is closer to the first LSP. The result of the experiment using eight samples of speech signals with a duration of around 8 seconds showed that there are more frames in which the first quantized LSP obtained by the latter manner is closer to the first LSP for all eight samples. In particular, this tendency is noticeable in a speech period.

Although in this embodiment, a case has been described as an example where encoding apparatus 100 includes two encoding sections, the number of encoding sections is not so limited and may be three or more.

Although in this embodiment, a case has been described as an example where decoding apparatus 150 includes two decoding sections, the number of decoding sections is not so limited and may be three or more.

As illustrated in this embodiment, if the frame loss information is "0", first decoding section 153 performs decoding using only first encoded information in the preceding frame. However, the present invention is applicable to a case in which first decoding section 153 performs decoding using second encoded information in the preceding frame in addition to the first encoded information in the preceding frame, and the same effect and result as this embodiment can be achieved. In this case, the first decoded signal can be obtained in the same way in which first decoding section 153 performs decoding when the frame loss information is "2".

As illustrated in this embodiment, flag information is used to indicate whether or not second encoded information is included in encoded information that is used for decoding by first decoding section 153. However, the present invention may be applied to a case in which second encoded information is always included in encoded information that is used for decoding by first decoding section 153 and no flag information is used, and the same effect and result as this embodiment can be achieved.

As illustrated in this embodiment, first decoding section 153 and second decoding section 154 may produce decoded signals using encoded information in the preceding frame as encoded information in the current frame. However, decoded signals may be produced in such a way in which a driving excitation is obtained by multiplying the encoded information in the preceding frame with a given factor of attenuation, so that the driving excitation generated in the current frame is some what attenuated from the driving excitation generated in the preceding frame. If, for example, the frame loss information is "2", quantized gain generating section 806 multiples the obtained first quantized adaptive excitation gain (first quantized fixed excitation gain) by a given factor of attenuation (e.g., 0.9) and outputs the multiplication result as the first quantized adaptive excitation gain (first quantized fixed excitation gain), and thereby it is possible to attenuate the driving excitation generated in the current frame.

As illustrated in this embodiment, if the frame loss information is "2", quantized gain generating section 806 adds the first quantized adaptive excitation gain in the preceding frame (first quantized fixed excitation gain in the preceding frame) and the second quantized adaptive excitation gain (second quantized fixed excitation gain), multiples the addition result by 0.5, and supplies the multiplication result as the first quantized adaptive excitation gain (first quantized fixed excitation gain). However, the first quantized adaptive excitation gain (first quantized fixed excitation gain) may be obtained by adding the first quantized adaptive excitation gain in the preceding frame (first quantized fixed excitation gain in the preceding frame) and the second quantized adaptive excitation gain (second quantized fixed excitation gain) at a given ratio. For example, first quantized adaptive excitation gain (first quantized fixed excitation gain) b_gain can be obtained by equation (7).

$$b\_gain = p\_gain \times \beta + e\_gain \times (1 - \beta) \qquad (7)$$

where, p_gain is the first quantized adaptive excitation gain in the preceding frame, e_gain is the second quantized adaptive excitation gain (second quantized fixed excitation gain), and β assumes any value from 0 to 1. The value of β can be set arbitrarily.

As illustrated in this embodiment, if the frame loss information is "1", quantized gain generating section 906 adds the first quantized adaptive excitation gain (first quantized fixed excitation gain) and the second quantized adaptive excitation gain in the preceding frame (second quantized fixed excitation gain in the preceding frame), multiples the addition result by 0.5, and supplies the multiplication result as the second quantized adaptive excitation gain (second quantized fixed excitation gain). However, the second quantized adaptive excitation gain (second quantized fixed excitation gain) may be obtained using the same method as above.

As illustrated in this embodiment, a case has been described as an example where decimal digits are used for frame loss information. However, the present invention may be applied to a case in which binary digits are used for frame loss information, and the same effect and result as this embodiment can be achieved. For example, to express the states of two encoded information (first and second encoded information) using binary digits, it is possible to use "1" to represent a state where data is received correctly and "0" to represent a state where data is not received correctly, and thereby frame loss information can be represented in two binary digits ("00" to "11").

As illustrated in this embodiment, a fixed excitation vector that is generated by fixed excitation codebook 208 is formed of pulses. However, the present invention may be applied to a case where spread pulses are used to form a fixed excitation vector, and the same effect and result as this embodiment can be achieved.

In this embodiment, a case has been described where the encoding sections and decoding sections performs encoding and decoding by the CELP type speech/sound encoding and decoding method. However, the present invention may be applied to cases where the encoding sections and decoding sections perform encoding and decoding by another speech/sound encoding and decoding method other than the CELP type (e.g., pulse code modulation, predictive coding, vector quantizing and vocoder), and the same effect and result as this embodiment can be achieved. The present invention may also be applied to a case in which the encoding sections and decoding sections use different speech/ sound encoding and decoding methods, and the same effect and result as this embodiment can be achieved.

(Embodiment 2)

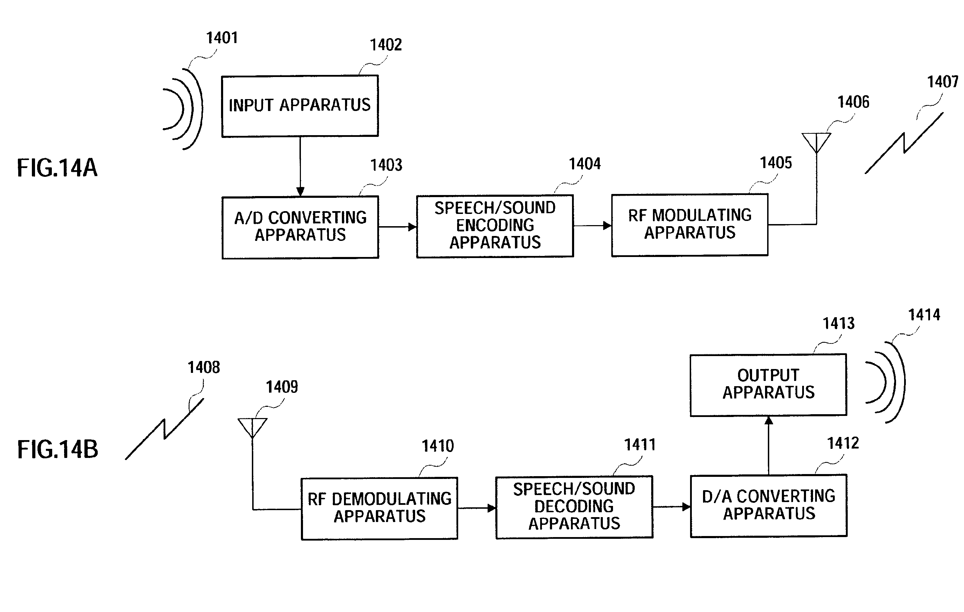

FIG. 14A is a block diagram showing a configuration of a speech/sound transmitting apparatus according to Embodiment 2 of the present invention, wherein the transmitting apparatus includes the encoding apparatus described in the above-described Embodiment 1.

Speech/sound signal 1401 is converted into an electric signal by input apparatus 1402 and the electric signal is outputted to A/D converting apparatus 1403. A/D converting apparatus 1403 converts the signal (analog) outputted from input apparatus 1402 into a digital signal and outputs the digital signal to speech/sound encoding apparatus 1404. Speech/sound encoding apparatus 1404 in which encoding apparatus 100 shown in FIG.1 is implemented, encodes the digital speech/sound signal outputted from A/D converting apparatus 1403 and outputs encoded information to RF modulating apparatus 1405. RFmodulating apparatus 1405 converts the encoded information outputted from speech/ sound encoding apparatus 1404 into a signal for transmission on a transmission medium such as radio waves and outputs the transmission signal to transmitting antenna 1406. Transmitting antenna 1406 transmits the output signal outputted from RF modulating apparatus 1405 as a radio wave (RF signal). In the figure, RF signal 1407 represents the radio wave (RF signal) transmitted from transmitting antenna 1406.

The above outlines the configuration and operation of the speech/sound signal transmitting apparatus.

FIG. 14B is a block diagram showing a configuration of a speech/sound receiving apparatus according to Embodiment 2 of the present invention, wherein the receiving apparatus includes the decoding apparatus described in the above-described Embodiment 1.

RF signal 1408 is received by receiving antenna 1409 and outputted to RF demodulating apparatus 1410. In the figure, RF signal 1408 represents the radio wave received by receiving antenna 1409 and is identical to RF signal 1407, unless the signal is attenuated or noise is superimposed on it in a transmission path.

RF demodulating apparatus 1410 demodulates the RF signal outputted from receiving antenna 1409 into encoded information and outputs the encoded information to speech/sound decoding apparatus 1411. Speech/sound decoding apparatus 1411 in which decoding apparatus 150 shown in FIG.1 is implemented, decodes the encoded information outputted from RF demodulating apparatus 1410 and outputs a decoded signal to D/A converting apparatus 1412. D/A converting apparatus 1412 converts the digital speech/sound signal outputted from speech/sound decoding apparatus 1411 into an analog electric signal and outputs this signal to output apparatus 1413. Output apparatus 1413 converts the electric signal into air vibration and outputs it as acoustic waves that can be heard by human ears. In the figure, reference numeral 1414 indicates outputted acoustic waves.

The above outlines the configuration and operation of the speech/sound receiving apparatus.

By providing the above speech/sound signal transmitting apparatus and speech/sound signal receiving apparatus in a base station apparatus and a communication terminal apparatus in a wireless communication system, high quality output signals can be obtained.

As described above, according to this embodiment, the encoding apparatus and the decoding apparatus according to the present invention can be implemented in the speech/sound signal transmitting apparatus and the speech/ sound signal receiving apparatus.

The encoding apparatus and the decoding apparatus according to the present invention are not limited to the above-described Embodiments 1 and 2 and can be changed and implemented in various ways.

It is possible to install the encoding apparatus and the decoding apparatus according to the present invention in a mobile terminal apparatus and a base station apparatus in a mobile communication system and provide a mobile terminal apparatus and a base station apparatus having the same effect and result as described above.

Although a case has been described as an example where the present invention is implemented with hardware. However, the present invention may be realized by software.

Industrial Applicability

The encoding apparatus and the decoding apparatus according to the present invention have an advantageous effect of obtaining decoded speech signals with good quality even if encoded information is lost, and are useful as a speech/sound encoding apparatus, a speech/sound decoding method, and the like for use in a communication system where speech/sound signals are encoded and transmitted.

**Claims**

1. A speech/sound decoding apparatus adapted to generate decoded signals by decoding encoded information encoded by scalable encoding and configured in a plurality of layers, the speech/sound decoding apparatus comprising:

   a frame loss detecting section adapted to determine whether or not encoded information in each of said layers in a received frame is correct, and generates frame loss information comprising a result of the determination; and decoding sections that are provided in the same number as said layers and that each is adapted to determine encoded information to be used for decoding of each layer from said received encoded information and a plurality of previously received encoded information, according to said frame loss information, and generates decoded signals by performing decoding using the determined encoded information;

   wherein, when a frame loss is detected in an i th layer, where i is an integer of 2 or greater, a decoding section for the i th layer selects at least one encoded information from received encoded information in a (i + 1) th and subsequent layers and encoded information of the i th layer in a preceding frame, and generates decoded signals by performing decoding using the selected encoded information.

2. The speech/sound decoding apparatus according to claim 1, wherein, when encoded information of a first layer is not received correctly, a decoding section for the first layer selects at least one encoded information from encoded information of a second layer and encoded information of the first layer in a preceding frame, and generates decoded signals by performing decoding using the selected encoded information.

3. The speech/sound decoding apparatus according to claim 1 or 2, wherein the frame loss information is represented by a numeric value indicating a reception state of encoded information.

4. The speech/sound decoding apparatus according to any of claims 1 to 3, wherein the frame loss information is represented by a binary number indicating a reception state of encoded information.

5. The speech/sound decoding apparatus according to any of claims 1 to 4, wherein at least one decoding section performs decoding by a CELP type speech/sound decoding method.

6. The speech/sound decoding apparatus according to claim 5, wherein a CELP type decoding section comprises:

   an LSP decoding section that decodes a quantized LSP code and generates a quantized LSP;
   an adaptive excitation vector generating section that decodes an adaptive excitation lag code and generates an adaptive excitation vector;
   a fixed excitation vector generating section that decodes a fixed excitation vector code and generates a fixed excitation vector;

a quantized excitation gain generating section that decodes a quantized excitation gain code and generates a quantized adaptive excitation gain and a quantized fixed excitation gain; and

an encoded information operating section that, when encoded information of an i th layer is not received correctly, selects at least one quantized LSP code from a plurality of quantized LSP codes included in encoded information in a (i + 1) th and subsequent layers and encoded information of the i th layer in the preceding frame,

wherein said LSP decoding section performs decoding using the quantized LSP code selected by said encoded information operating section and generates the quantized LSP.

7. The speech/sound decoding apparatus according to claim 6, wherein said LSP decoding section adds all quantized LSPs obtained by decoding quantized LSP codes selected by said encoded information operating section and uses an addition result as the quantized LSP.

8. The speech/sound decoding apparatus according to claim 6, wherein:

when encoded information of an i th layer is not received correctly, said encoded information operating section selects at least one adaptive excitation lag code from a plurality of adaptive excitation lag codes included in encoded information of a (i + 1) th and subsequent layers and encoded information of the i th layer in the preceding frame; and

said adaptive excitation vector generating section performs decoding using the adaptive excitation lag code selected by said encoded information operating section and generates the adaptive excitation vector.

9. The speech/sound decoding apparatus according to claim 6, wherein said adaptive excitation vector generating section adds all adaptive excitation lags obtained by decoding adaptive excitation lag codes selected by said encoded information operating section and generates the adaptive excitation vector using an addition result.

10. The speech/sound decoding apparatus according to claim 6, wherein:

when encoded information of an i th layer is not received correctly, said encoded information operating section selects at least one quantized excitation gain code from a plurality of quantized excitation gain codes included in encoded information in a (i + 1) th and subsequent layers and i-th layer encoded information in the preceding frame; and

said quantized excitation gain generating section performs decoding using the quantized excitation gain code selected by said encoded information operating section and generates the quantized adaptive excitation gain and the quantized fixed excitation gain.

11. The speech/sound decoding apparatus according to claim 6, wherein said quantized excitation gain generating section adds at a fixed ratio all quantized adaptive excitation gains obtained by decoding quantized adaptive excitation gain codes selected by said encoded information operating section, uses an addition result as the quantized adaptive excitation gain, adds at a given ratio all quantized fixed excitation gains obtained by decoding the quantized adaptive excitation gain codes and uses an addition result as the quantized fixed excitation gain.

12. A speech/sound signal receiving apparatus comprising the speech/sound decoding apparatus according to any of claims 1 to 11.

13. A base station apparatus comprising the speech/sound signal receiving apparatus according to claim 12.

14. A communication terminal apparatus comprising the speech/sound signal receiving apparatus according to claim 12.

15. A speech/sound decoding method for generating decoded signals by decoding encoded information encoded by scalable encoding and configured in a plurality of layers, the speech/sound decoding method comprising:

a frame loss detection step of determining whether or not encoded information in each of said layers in a received frame is correct and generating frame loss information comprising a result of the determination; and

a decoding step, performed the same number of times as the number of said layers, of determining encoded information to be used for decoding in each layer from said received encoded information and a plurality of previously received encoded information, according to said frame loss information, and generating decoded signals by performing decoding using the determined encoded information

wherein, when a frame loss is detected in an i th layer, where i is an integer of 2 or greater, a decoding section for the i th layer selects at least one encoded information from received encoded information in a (i + 1) th and subsequent layers and encoded information of the i th layer in a preceding frame, and generates decoded signals by performing decoding using the selected encoded information.

**Patentansprüche**

1. Sprach-/Ton-Decodiervorrichtung, die so eingerichtet ist, dass sie decodierte Signale erzeugt, indem sie mittels skalierbarer Codierung codierte und in einer Vielzahl von Schichten konfigurierte codierte Informationen decodiert, wobei die Sprach-/Ton-Decodiervorrichtung umfasst:

   einen Rahmenverlust-Erfassungsabschnitt, der so eingerichtet ist, dass er feststellt, ob codierte Informationen in jeder der Schichten in einem empfangenen Rahmen korrekt sind oder nicht, und Rahmenverlust-Informationen erzeugt, die ein Ergebnis der Feststellung umfassen; und
   Decodierabschnitte, die in der gleichen Anzahl wie die Schichten vorhanden sind und die jeweils so eingerichtet ist, dass sie codierte Informationen, die zum Decodieren jeder Schicht verwendet werden sollen, aus den empfangen codierten Informationen und einer Vielzahl zuvor empfangener codierter Informationen entsprechend den Rahmenverlust-Informationen bestimmen und decodierte Signale erzeugen, indem sie Decodieren unter Verwendung der bestimmten codierten Informationen durchführen;

   wobei, wenn ein Rahmenverlust in einer i-ten Schicht erfasst wird, wobei i eine ganze Zahl gleich oder größer als 2 ist, ein Decodierabschnitt für die i-te Schicht wenigstens eine codierte Information aus empfangenen codierten Informationen in einer (i + 1)-ten und folgenden Schicht/en sowie codierte Informationen der i-ten Schicht in einem vorhergehenden Rahmen auswählt und decodierte Signale erzeugt, indem er Decodierung unter Verwendung der ausgewählten codierten Informationen durchführt.

2. Sprach-/Ton-Decodiervorrichtung nach Anspruch 1, wobei, wenn codierte Informationen einer ersten Schicht nicht korrekt empfangen werden, ein Decodierabschnitt für die erste Schicht wenigstens eine codierte Information aus codierten Informationen einer zweiten Schicht und codierte Informationen der ersten Schicht in einem vorhergehenden Rahmen auswählt und decodierte Signale erzeugt, indem er Decodieren unter Verwendung der ausgewählten codierten Informationen durchführt.

3. Sprach-/Ton-Decodiervorrichtung nach Anspruch 1 oder 2, wobei die Rahmenverlust-Informationen durch einen numerischen Wert dargestellt werden, der einen Empfangszustand codierter Informationen anzeigt.

4. Sprach-/Ton-Decodiervorrichtung nach einem der Ansprüche 1 bis 3, wobei die Rahmenverlust-Informationen durch eine Binärzahl dargestellt werden, die einen Empfangszustand codierter Informationen anzeigen.

5. Sprach-/Ton-Decodiervorrichtung nach einem der Ansprüche 1 bis 4, wobei wenigstens ein Decodierabschnitt Decodieren mittels eines Sprach-/Ton-Decodierverfahrens vom CELP-Typ durchführt.

6. Sprach-/Ton-Decodiervorrichtung nach Anspruch 5, wobei ein Decodierabschnitt vom CELP-Typ umfasst:

   einen LSP-Decodierabschnitt, der einen quantisierten LSP-Code decodiert und ein quantisiertes LSP erzeugt;
   einen Abschnitt zum Erzeugen eines adaptiven Anregungsvektors, der einen adaptiven Anregungs-Verschiebungs-Code (adaptive excication lag code) decodiert und einen adaptiven Anregungsvektor erzeugt;
   einen Abschnitt zum Erzeugen eines festen Anregungsvektors, der einen Code mit festem Anregungsvektor decodiert und einen festen Anregungsvektor erzeugt;
   einen Abschnitt zum Erzeugen einer quantisierten Anregungsverstärkung, der einen quantisierten Anregungsverstärkungs-Code decodiert und eine quantisierte adaptive Anregungsverstärkung sowie eine quantisierte feste Anregungsverstärkung erzeugt; und
   einen Abschnitt zum Bearbeiten codierter Informationen, der, wenn codierte Informationen einer i-ten Schicht nicht korrekt empfangen werden, wenigstens einen quantisierten LSP-Code aus einer Vielzahl quantisierter LSP-Codes auswählt, die in codierten Informationen in einer (i + 1)-ten und folgenden Schichten sowie codierten Informationen der i-ten Schicht in dem vorhergehenden Rahmen enthalten sind,

wobei der LSP-Decodierabschnitt Decodieren unter Verwendung des durch den Abschnitt zum Bearbeiten codierter Informationen ausgewählten quantisierten LSP-Codes durchführt und das quantisierte LSP erzeugt.

7.  Sprach-/Ton-Decodiervorrichtung nach Anspruch 6, wobei der LSP-Decodierabschnitt alle quanitisierten LSP addiert, die gewonnen werden, indem durch den Abschnitt zum Bearbeiten codierter Informationen ausgewählte quantisierte LSP-Codes decodiert werden, und er ein Additionsergebnis als das quantisierte LSP verwendet.

8.  Sprach-/Ton-Decodiervorrichtung nach Anspruch 6, wobei:

    wenn codierte Informationen einer i-ten Schicht nicht korrekt empfangen werden, der Abschnitt zum Bearbeiten codierter Informationen wenigstens einen adaptiven Anregungs-Lag-Code aus einer Vielzahl adaptiver Anregungs-Verschiebungs-Codes auswählt, die in codierten Informationen einer (i + 1)-ten und folgender Schichten sowie codierten Informationen der i-ten Schicht in dem vorhergehenden Rahmen enthalten sind; und
    der Abschnitt zum Erzeugen eines adaptiven Anregungsvektors Decodieren unter Verwendung des durch den Abschnitt zum Bearbeiten codierter Informationen ausgewählten adaptiven Anregungs-Verschiebungs-Codes durchführt und den adaptiven Anregungsvektor erzeugt.

9.  Sprach-/Ton-Decodiervorrichtung nach Anspruch 6, wobei der Abschnitt zum Erzeugen eines adaptiven Anregungsvektors alle adaptiven Anregungs-Verschiebungen addiert, die gewonnen werden, indem durch den Abschnitt zum Bearbeiten codierter Informationen ausgewählte adaptive Anregungs-Verschiebungs-Codes decodiert werden, und er den adaptiven Anregungsvektor unter Verwendung eines Additionsergebnisses erzeugt.

10. Sprach-/Ton-Decodiervorrichtung nach Anspruch 6, wobei:

    wenn codierte Informationen einer i-ten Schicht nicht korrekt empfangen werden, der Abschnitt zum Bearbeiten codierter Informationen wenigstens einen quantisierten Anregungs-Verstärkungs-Code aus einer Vielzahl quantisierter Anregungs-Verstärkungs-Codes auswählt, die in codierten Informationen in einer (i + 1)-ten und folgender Schichten sowie codierten Informationen der i-ten Schicht in dem vorhergehenden Rahmen enthalten sind; und
    der Abschnitt zum Erzeugen einer quantisierten Anregungs-Verstärkung Decodieren unter Verwendung des durch den Abschnitt zum Bearbeiten codierter Informationen ausgewählten Quantisierungs-Anregungs-Verstärkungs-Codes durchführt und die quantisierte adaptive Anregungs-Verstärkung sowie die quantisierte feste Anregungs-Verstärkung erzeugt.

11. Sprach-/Ton-Decodiervorrichtung nach Anspruch 6, wobei der Abschnitt zum Erzeugen einer quantisierten Anregungs-Verstärkung in einem festen Verhältnis alle quantisierten adaptiven Anregungs-Verstärkungen addiert, die gewonnen werden, indem durch den Abschnitt zum Bearbeiten codierter Informationen ausgewählte adaptive Anregungs-Verstärkungs-Codes decodiert werden, er ein Additionsergebnis als die quantisierte adaptive Anregungs-Verstärkung verwendet und in einem vorgegebenen Verhältnis alle quantisierten festen Anregungs-Verstärkungen addiert, die mittels Decodieren der quantisierten adaptiven Anregungs-Verstärkungs-Codes gewonnen werden, und ein Additionsergebnis als die quanitisierte feste Anregungs-Verstärkung verwendet.

12. Sprach-/Tonsignal-Empfangsvorrichtung, die Sprach-/Ton-Decodiervorrichtung nach einem der Ansprüche 1 bis 11 umfasst.

13. Basisstationsvorrichtung, die die Sprach-/Tonsignal-Empfangsvorrichtung nach Anspruch 12 umfasst.

14. Kommunikations-Endgerätvorrichtung, die die Sprach-/Tonsignal-Empfangsvorrichtung nach Anspruch 12 umfasst.

15. Sprach-/Ton-Decodierverfahren zum Erzeugen decodierter Signale durch Decodieren mittels skalierbarem Codieren codierter und in einer Vielzahl von Schichten konfigurierter codierter Informationen, wobei das Sprach-/Ton-Decodierverfahren umfasst:

    einen Rahmenverlust-Erfassungsschritt, in dem festgestellt wird, ob codierte Informationen in jeder der Schichten in einem empfangenen Rahmen korrekt sind oder nicht, und Rahmenverlust-Informationen erzeugt werden, die ein Ergebnis der Feststellung umfassen;
    einen Decodierschritt, der mit einer Häufigkeit durchgeführt wird, die der Anzahl der Schichten entspricht, und in dem codierte Informationen, die zum Decodieren in jeder Schicht verwendet werden sollen, aus den emp-

**EP 1 750 254 B1**

fangenen codierten Informationen und einer Vielzahl zuvor empfangener codierter Informationen entsprechend den Rahmenverlust-Informationen bestimmt werden und decodierte Signale erzeugt werden, indem Decodieren unter Verwendung der bestimmten codierten Informationen durchgeführt wird;

wobei, wenn ein Rahmenverlust in einer i-ten Schicht erfasst wird, wobei i eine ganze Zahl gleich oder größer als 2 ist, ein Decodierabschnitt für die i-te Schicht wenigstens eine codierte Information aus empfangenen codierten Informationen in einer (i + 1)-ten und folgenden Schicht/en sowie codierte Informationen der i-ten Schicht in einem vorhergehenden Rahmen auswählt und decodierte Signale erzeugt, indem er Decodierung unter Verwendung der ausgewählten codierten Informationen durchführt.

**Revendications**

1. Appareil de décodage de la voix ou du son conçu pour générer des signaux décodés en décodant des informations codées qui ont été codées par un codage adaptatif et configurées dans une pluralité de couches, l'appareil de décodage de la voix ou du son comprenant :

   une section de détection de perte de trame conçue pour déterminer si des informations codées dans chacune desdites couches d'une trame reçue sont correctes ou non, et pour générer des informations de perte de trame comprenant le résultat de la détermination, et
   des sections de décodage qui sont prévues en nombre identique à celui desdites couches et qui sont conçues chacune pour déterminer des informations codées à utiliser pour le décodage de chaque couche à partir desdites informations codées reçues et d'une pluralité d'informations codées reçues précédemment, en fonction desdites informations de perte de trame, ainsi que pour générer des signaux décodés en effectuant un décodage en utilisant les informations codées déterminées,

   dans lequel, lorsqu'une perte de trame est détectée dans une i ième couche, où i est un nombre entier de 2 ou plus, une section de décodage pour la i ième couche sélectionne au moins une information codée à partir des informations codées reçues dans une (i + 1) ième couche et dans les couches suivantes, et à partir des informations codées de la i ième couche dans une trame précédente, et elle génère des signaux décodés en effectuant un décodage en utilisant les informations sélectionnées codées.

2. Appareil de décodage de la voix ou du son selon la revendication 1, dans lequel, lorsque les informations codées d'une première couche ne sont pas correctement reçues, une section de décodage pour la première couche sélectionne au moins une information codée à partir des informations codées d'une seconde couche, ainsi que des informations codées de la première couche dans une trame précédente, et elle génère des signaux décodés en effectuant un décodage en utilisant les informations sélectionnées codées.

3. Appareil de décodage de la voix ou du son selon la revendication 1 ou 2, dans lequel les informations de perte de trame sont représentées par une valeur numérique indiquant l'état de réception des informations codées.

4. Appareil de décodage de la voix ou du son selon l'une quelconque des revendications 1 à 3, dans lequel les informations de perte de trame sont représentées par un nombre binaire indiquant l'état de réception des informations codées.

5. Appareil de décodage de la voix ou du son selon l'une quelconque des revendications 1 à 4, dans lequel au moins une section de décodage effectue un décodage grâce à un procédé de décodage de parole ou de son par prédiction linéaire de type CELP.

6. Appareil de décodage de la voix ou du son selon la revendication 5, dans lequel une section de décodage par prédiction linéaire de type CELP comprend :

   une section de décodage de paire de raies spectrales (LSP) qui décode un code de paire LSP quantifiée et génère une paire LSP quantifiée,
   une section de génération de vecteur d'excitation adaptative qui décode un code de retard d'excitation adaptative et génère un vecteur d'excitation adaptative,
   une section de génération de vecteur d'excitation fixe qui décode un code de vecteur d'excitation fixe et génère un vecteur d'excitation fixe,

une section de génération de gain d'excitation quantifiée qui décode un code de gain d'excitation quantifiée et génère un gain d'excitation adaptative quantifiée et un gain d'excitation fixe quantifiée, et

une section agissant sur les informations codées qui, lorsque les informations codées d'une i ième couche ne sont pas correctement reçues, sélectionne au moins un code de paire LSP quantifiée à partir d'une pluralité de codes de paires LSP quantifiées incluses dans les informations codées dans une (i + 1) ième couche et dans les couches suivantes, ainsi que dans les informations codées de la i ième couche dans la trame précédente,

dans lequel ladite section de décodage de paire LSP effectue un décodage en utilisant le code de paire LSP quantifiée, sélectionné par ladite section agissant sur les informations codées, et elle génère la paire LSP quantifiée.

7. Appareil de décodage de la voix ou du son selon la revendication 6, dans lequel ladite section de décodage de paire LSP ajoute toutes les paires LSP quantifiées obtenues par le décodage des codes des paires LSP quantifiées, sélectionnées par ladite section agissant sur les informations codées, et elle utilise le résultat de l'addition comme étant la paire LSP quantifiée.

8. Appareil de décodage de la voix ou du son selon la revendication 6, dans lequel :

lorsque les informations codées d'une i ième couche ne sont pas correctement reçues, ladite section agissant sur les informations codées sélectionne au moins un code de retard d'excitation adaptative à partir d'une pluralité de codes de retards d'excitation adaptative inclus dans les informations codées d'une (i + 1) ième couche et des couches suivantes, ainsi que dans les informations codées de la i ième couche dans la trame précédente, et ladite section de génération de vecteur d'excitation adaptative effectue un décodage en utilisant le code de retard d'excitation adaptative, sélectionné par ladite section agissant sur les informations codées, et elle génère le vecteur d'excitation adaptative.

9. Appareil de décodage de la voix ou du son selon la revendication 6, dans lequel ladite section de génération de vecteur d'excitation adaptative ajoute tous les retards d'excitation adaptative obtenus par le décodage des codes de retards d'excitation adaptative, sélectionnés par ladite section agissant sur les informations codées, et elle génère le vecteur d'excitation adaptative en utilisant le résultat de l'addition.

10. Appareil de décodage de la voix ou du son selon la revendication 6, dans lequel :

lorsque les informations codées d'une i ième couche de ne sont pas correctement reçues, ladite section agissant sur les informations codées sélectionne au moins un code de gain d'excitation quantifiée à partir d'une pluralité de codes de gains d'excitation quantifiée inclus dans les informations codées dans une (i + 1) ième couche et dans les couches suivantes, ainsi que dans les informations codées de la i ième couche dans la trame précédente, et ladite section de génération de gain d'excitation quantifiée effectue le décodage en utilisant le code de gain d'excitation quantifiée, sélectionné par ladite section agissant sur les informations codées, et elle génère le gain d'excitation adaptative quantifiée et le gain d'excitation fixe quantifiée.

11. Appareil de décodage de la voix ou du son selon la revendication 6, dans lequel ladite section de génération de gain d'excitation quantifiée ajoute, avec un taux fixe, tous les gains d'excitation adaptative quantifiée, obtenus en décodant les codes de gains d'excitation adaptative quantifiée, sélectionnés par ladite section agissant sur les informations codées, elle utilise le résultat de l'addition comme gain d'excitation adaptative quantifiée, ajoute, à un taux donné, tous les gains d'excitation fixe quantifiée, obtenus en décodant les codes de gains d'excitation adaptative quantifiée, et elle utilise le résultat de l'addition comme gain d'excitation fixe quantifiée.

12. Appareil de réception d'un signal de voix ou de son comprenant l'appareil de décodage de la voix ou du son conforme à l'une quelconque des revendications 1 à 11.

13. Station de base comprenant l'appareil de réception de signal de voix ou de son conforme à la revendication 12.

14. Terminal de communication comprenant l'appareil de réception de signal de voix ou de son conforme à la revendication 12.

15. Procédé de décodage de voix ou de son permettant de générer des signaux décodés en décodant des informations codées qui ont été codées par un codage adaptatif et configurées dans une pluralité de couches, le procédé de décodage de voix ou de son comprenant :

une étape de détection de perte de trame consistant à déterminer si des informations codées dans chacune desdites couches dans une trame reçue sont correctes ou non, et à générer des informations de perte de trame comprenant le résultat de la détermination, et
une étape de décodage, effectuée le même nombre de fois que le nombre desdites couches, consistant à déterminer des informations codées à utiliser pour effectuer un décodage dans chaque couche à partir desdites informations codées reçues et d'une pluralité d'informations codées reçues précédemment en fonction desdites informations de perte de trame, et consistant à générer des signaux décodés en effectuant un décodage en utilisant les informations déterminées codées,

dans lequel, lorsqu'une perte de trame est détectée dans une i ième couche, où i est un nombre entier de 2 ou plus, une section de décodage pour la i ième couche sélectionne au moins une information codée à partir des informations codées reçues dans une (i + 1) ième couche et dans les couches suivantes, et à partir des informations codées de la i ième couche dans une trame précédente, et elle génère des signaux décodés en effectuant un décodage en utilisant les informations sélectionnées codées.

FIG.1

FIG.2

FIG.3

FIG.4

EP 1 750 254 B1

FIG.5

EP 1 750 254 B1

FIG.6

EP 1 750 254 B1

FIG.7

FIG.8

EP 1 750 254 B1

FIG.9

QUANTIZED RESIDUAL LSP

2ND ADAPTIVE
EXCITATION LAG

2ND QUANTIZED ADAPTIVE
EXCITATION GAIN

2ND QUANTIZED FIXED
EXCITATION GAIN

FRAME LOSS
INFORMATION

1ST QUANTIZED LSP

1ST ADAPTIVE EXCITATION
LAG

1ST FIXED
EXCITATION VECTOR

1ST QUANTIZED ADAPTIVE
EXCITATION GAIN

1ST QUANTIZED FIXED
EXCITATION GAIN

811

1001

FRAME LOSS
INFORMATION
DISTRIBUTING
SECTION

1004

1003

1002

SND ENCODED
INFORMATION
DISTRIBUTING
SECTION

ENCODED
INFORMATION
STORAGE SECTION

1ST ENCODED
INFORMATION
DISTRIBUTING
SECTION

QUANTIZED RESIDUAL LSP

2ND ADAPTIVE
EXCITATION LAG

2ND QUANTIZED ADAPTIVE
EXCITATION GAIN

2ND QUANTIZED FIXED
EXCITATION GAIN

1ST QUANTIZED LSP

1ST ADAPTIVE
EXCITATION LAG

1ST QUANTIZED ADAPTIVE
EXCITATION GAIN

1ST QUANTIZED FIXED
EXCITATION GAIN

1ST QUANTIZED LSP IN
PRECEDING FRAME

1ST ADAPTIVE EXCITATION
LAG IN PRECEDING FRAME

FIXED EXCITATION VECTOR IN
PRECEDING FRAME

1ST QUANTIZED ADAPTIVE EXCITATION
GAIN IN PRECEDING FRAME

1ST QUANTIZED FIXED EXCITATION
GAIN IN PRECEDING FRAME

FIG.10

EP 1 750 254 B1

FIG.11

QUANTIZED RESIDUAL LSP
2ND ADAPTIVE EXCITATION LAG
2ND FIXED EXCITATION VECTOR
2ND QUANTIZED ADAPTIVE EXCITATION GAIN
2ND QUANTIZED FIXED EXCITATION GAIN

FRAME LOSS INFORMATION

1ST QUANTIZED LSP
1ST ADAPTIVE EXCITATION LAG
1ST QUANTIZED ADAPTIVE EXCITATION GAIN
1ST QUANTIZED FIXED EXCITATION GAIN
1ST QUANTIZED LSP IN PRECEDING FRAME
1ST ADAPTIVE EXCITATION LAG IN PRECEDING FRAME

FRAME LOSS INFORMATION

1101 FRAME LOSS INFORMATION DISTRIBUTING SECTION

1102 1ST ENCODED INFORMATION DISTRIBUTING SECTION

1103 ENCODED INFORMATION STORAGE SECTION

1104 SND ENCODED INFORMATION DISTRIBUTING SECTION

911

1ST QUANTIZED LSP
1ST ADAPTIVE EXCITATION LAG
1ST QUANTIZED ADAPTIVE EXCITATION GAIN
1ST QUANTIZED FIXED EXCITATION GAIN
1ST QUANTIZED LSP IN PRECEDING FRAME
1ST ADAPTIVE EXCITATION LAG IN PRECEDING FRAME

QUANTIZED RESIDUAL LSP
2ND ADAPTIVE EXCITATION LAG
2ND QUANTIZED ADAPTIVE EXCITATION GAIN
2ND QUANTIZED FIXED EXCITATION GAIN
QUANTIZED RESIDUAL LSP IN PRECEDING FRAME
2ND ADAPTIVE EXCITATION LAG IN PRECEDING FRAME
2ND FIXED EXCITATION VECTOR IN PRECEDING FRAME
2ND QUANTIZED ADAPTIVE EXCITATION GAIN IN PRECEDING FRAME
2ND QUANTIZED FIXED EXCITATION GAIN IN PRECEDING FRAME

38

| FRAME LOSS INFORMATION | 1ST ENCODED INFORMATION | 2ND ENCODED INFORMATION | PARAMETERS USED BY 1ST DECODING SECTION 153 | | PARAMETERS USED BY 2ND DECODING SECTION 154 | |
|---|---|---|---|---|---|---|
| 3 | RECEIVED CORRECTLY | RECEIVED CORRECTLY | LSP DECODING SECTION | lsp | LSP DECODING SECTION | lsp.d_lsp |
| | | | ADAPTIVE EXCITATION CODEBOOK | lag | ADAPTIVE EXCITATION CODEBOOK | lag.d_lag |
| | | | FIXED EXCITATION CODEBOOK | sc | FIXED EXCITATION CODEBOOK | e_sc |
| | | | QUANTIZED GAIN GENERATING SECTION | ga.gs | QUANTIZED GAIN GENERATING SECTION | e_ga.e_gs |
| 2 | LOSS | RECEIVED CORRECTLY | LSP DECODING SECTION | p_lsp.d_lsp | LSP DECODING SECTION | p_lsp.d_lsp |
| | | | ADAPTIVE EXCITATION CODEBOOK | p_lag.d_lag | ADAPTIVE EXCITATION CODEBOOK | p_lag.d_lag |
| | | | FIXED EXCITATION CODEBOOK | p_sc | FIXED EXCITATION CODEBOOK | e_sc |
| | | | QUANTIZED GAIN GENERATING SECTION | p_ra.p_gs.e_ga.e_gs | QUANTIZED GAIN GENERATING SECTION | e_ga.e_gs |
| 1 | RECEIVED CORRECTLY | LOSS | LSP DECODING SECTION | lsp | LSP DECODING SECTION | lsp.p_d_lsp |
| | | | ADAPTIVE EXCITATION CODEBOOK | lag | ADAPTIVE EXCITATION CODEBOOK | lag.p_d_lag |
| | | | FIXED EXCITATION CODEBOOK | ac | FIXED EXCITATION CODEBOOK | p_e_sc |
| | | | QUANTIZED GAIN GENERATING SECTION | ga.ga | QUANTIZED GAIN GENERATING SECTION | ga.gs.p_e_ga.p_e_gs |
| 0 | LOSS | LOSS | LSP DECODING SECTION | p_lsp | LSP DECODING SECTION | p_lsp.p_d_lsp |
| | | | ADAPTIVE EXCITATION CODEBOOK | p_lap | ADAPTIVE EXCITATION CODEBOOK | p_lag.p_d_lag |
| | | | FIXED EXCITATION CODEBOOK | p_sc | FIXED EXCITATION CODEBOOK | p_e_sc |
| | | | QUANTIZED GAIN GENERATING SECTION | p_ga.p_gs | QUANTIZED GAIN GENERATING SECTION | p_e_ga.p_e_gs |

FIG.12

1300    1301    1302    1303

FIG.13

EP 1 750 254 B1

**FIG.14A**

1401

1402 INPUT APPARATUS

1403 A/D CONVERTING APPARATUS

1404 SPEECH/SOUND ENCODING APPARATUS

1405 RF MODULATING APPARATUS

1406

1407

**FIG.14B**

1408

1409

1410 RF DEMODULATING APPARATUS

1411 SPEECH/SOUND DECODING APPARATUS

1412 D/A CONVERTING APPARATUS

1413 OUTPUT APPARATUS

1414

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP HEI1097295 B

• JP 2002268969 A

**Non-patent literature cited in the description**

• **M.R.Schroeder ; B. S. Atal.** Code Excited Linear Prediction: High Quality Speech at Low Bit Rate. *IEEE proc., ICASSP,* vol. 85, 937-940